# EUROPÄISCHE PATENTSCHRIFT

(11) **EP 2 436 038 B1**
(45) Veröffentlichungstag und Bekanntmachung des Hinweises auf die Patenterteilung: **04.10.2017**
(21) Anmeldenummer: 10721344.9
(22) Anmeldetag: 26.05.2010
(51) Int. Cl.: H02S 40/34, H01L 31/02

(54) **Solarpaneel, Verfahren zum Herstellen und Überbrückungsdose**
Solar panel, method for producing the same and bypass plug
Panneau solaire, procédé de fabrication de ce panneau et boîte de pontage

(30) Priorität: 27.05.2009 DE 102009022943
(43) Veröffentlichungstag der Anmeldung: 04.04.2012
(73) Patentinhaber: Yamaichi Electronics Deutschland GmbH, 85609 Aschheim-Dornach (DE); Hanwha Q.CELLS GmbH, 06766 Bitterfeld-Wolfen (DE)
(72) Erfinder: EBERLE, Erwin, 80687 München (DE); QUITER, Michael, 57482 Wenden (DE); DREWITZ, Hagen, 04129 Leipzig (DE); TRÄGER, Markus, 04107 Leipzig (DE)
(74) Vertreter: Müller-Boré & Partner Patentanwälte PartG mbB
(86) Internationale Anmeldenummer: PCT/EP2010/003197
(87) Internationale Veröffentlichungsnummer: WO 2010/136189

(56) Entgegenhaltungen:
- EP-A2- 1 589 588
- WO-A2-2008/148524
- DE-A1-102007 020 845
- DE-A1-102007 031 351
- DE-U1-202008 006 119

## Beschreibung

Die vorliegende Erfindung betrifft ein Solarpaneel, ein Verfahren zum Herstellen, eine Anschlußdose und eine Überbrückungsdose.

Herkömmliche Solarmodule zur Erzeugung elektrischer Energie aus Sonnenlicht umfassen eine oder mehrere einzelne Solarzellen. Je nach gewünschter vom Solarmodul zur Verfügung zu stellender Spannung und/oder Stromstärke werden einzelne Solarzellen innerhalb des Moduls parallel und/oder in Reihe geschaltet und damit zu Solarzellengruppen zusammengefaßt. Die Solarzellengruppen werden zu einem flachen Solarmodul zusammengefaßt.

Die elektrischen Anschlüsse der Solarzellengruppen des Solarmoduls werden nach außen geführt. Bei partieller Verringerung der Bestrahlungsintensität durch Sonnenlicht auf einzelne Solarzellen bzw. Solarzellengruppen, beispielsweise durch Verschmutzung oder Schattenwurf, können unter anderem folgende Effekte auftreten:
(1) Eine (gleichmäßige) Verringerung der Bestrahlungsintensität innerhalb der zusammen geschalteten Solarzellengruppen führt zu einer Leistungsverminderung der jeweiligen Solarzellengruppe.
(2) Durch eine partielle Abschattung einer Solarzelle innerhalb einer Solarzellengruppe wirkt diese abgeschattete Solarzelle als Sperrdiode bzw. Widerstand innerhalb des Stromkreises der Solarzellengruppe, was zum einen dazu führen kann, daß die gesamte Solarzellengruppe keine elektrische Energie mehr liefern kann und zum anderen zu einer Beschädigung der abgeschatteten Solarzelle und damit zum dauerhaften Ausfall der Solarzellengruppe führen kann.

In jedem Fall können zwischen den herausgeführten Anschlüssen der Solarzellengruppen eines Solarmoduls, je nach Bestrahlungsintensität auf die einzelnen Solarzellen, unterschiedliche Spannungen anliegen. Eine Reihenschaltung der Solarzellengruppen durch entsprechende Schaltung der nach außen geführten Anschlüsse führt analog zu den oben genannten Problemen.

Um die mit der unterschiedlichen Bestrahlungsintensität der Solarzellen verbundenen Probleme zu vermeiden, werden herkömmlich sogenannte Bypass-Dioden verwendet, die elektrisch antiparallel zu den Solarzellengruppen geschaltet werden. Diese Bypass-Dioden haben die Wirkung, daß der Stromfluß durch das Solarmodul an Solarzellengruppen, welche eine nur geringe Leistung liefern, vorbei geleitet wird, d.h. die Anschlüsse dieser Solarzellengruppe eines Solarmoduls werden durch die Bypass-Diode kurzgeschlossen und die entsprechende Solarzellengruppe dadurch überbrückt. Somit liefert eine solche Solarzellengruppe zwar keinen Anteil mehr zur Gesamtleistung des Solarmoduls oder eines Solarstranges einer Solaranlage, der Gesamtstromfluß durch das Solarpaneel ist jedoch im wesentlichen ungehindert und eine Beschädigung einzelner Solarzellen wird verhindert.

Solarpaneele umfassen daher neben dem Solarmodul in der Regel eine elektrische Anschlußdose mit einer Vielzahl von Kontaktvorrichtungen und einer entsprechend angepaßten Anzahl von Bypass-Dioden. Ferner sind die Solarzellen in einem Solarmodul in der Regel durch flache dünne Leiterbänder miteinander verbunden. Diese Leiterbänder werden aus dem Solarmodul heraus geführt und manuell mit den in der Anschlußdose angeordneten Kontaktvorrichtungen kontaktiert, so daß einerseits der erzeugte Strom aus dem Solarmodul heraus geführt werden kann und andererseits die Solarzellen falls nötig überbrückt werden können. Das mit der Anschlußdose versehene Solarmodul wird als Solarpaneel bezeichnet.

Die Druckschrift WO 2008/148524 A3 offenbart ein Solarmodul zur Erzeugung elektrischer Energie mit einer Schichtenanordnung, umfassend eine flächenartige erste Schicht, eine flächenartige zweite Schicht, die mit einem Abstand zu der ersten Schicht angeordnet ist, und wenigstens eine Solarzelle zur Erzeugung von elektrischer Energie infolge eingestrahlter Strahlung, die zwischen der ersten und zweiten Schicht angeordnet ist. Ein elektrisches Anschlußsystem dient zur elektrischen Verschaltung der Solarzelle und umfaßt ein Verbinderelement zum externen elektrischen Anschluß des Moduls und ein Überbrückungselement zur Verbindung zweier Solarzellengruppen des Solarmoduls. Das Verbinderelement bzw. das Überbrückungselement sind an der Kante des Solarpanels angeordnet, wobei elektrische Kontakt des Verbinderelements bzw. des Überbrückungselements zwischen die erste und zweite Schicht ragen.

Die Druckschrift DE 10 2007 020 845 A1 offenbart eine Solarpaneeldose zum elektrischen Anschluß eines Photovoltaik-Moduls für eine Solaranlage, mit einem Basisteil zum Anbringen auf dem Photovoltaik-Modul und zum elektrischen Anschließen einer Anschlußleitung des Photovoltaik-Moduls. Das Basisteil weist eine Ausnehmung auf, welche vergießbar ist.

Es ist Aufgabe der Erfindung, ein Solarpaneel bereitzustellen, welches in einfacher Weise materialsparend und betriebssicher hergestellt werden kann, sowie ein entsprechende Verfahren zum Herstellen des Solarpaneels und eine Überbrückungsdose.

Die Aufgabe wird durch die unabhängigen Ansprüche gelöst. Bevorzugte Ausführungsvarianten und/oder Ausführungsformen sind Gegenstand der abhängigen Ansprüche.

### Solarpaneel gemäß einem Aspekt

Ein Aspekt der vorliegenden Erfindung betrifft ein Solarpaneel, umfassend:
- ein Solarmodul mit zumindest vier elektrischen Leitern,
- eine elektrische Eingangsanschlußdose, mit
   -- einem Eingangsanschlußdosenanordnungselement und
   -- einer Eingangsanschlußdosenkontakteinrichtung mit zwei Leiterkontakten und zumindest einer Diode,
   wobei zwei der elektrischen Leiter des Solarmoduls jeweils mit einem zugeordneten Leiterkontakt der Eingangsanschlußdosenkontakteinrichtung kontaktiert sind, und
   wobei die zwei Leiterkontakte mittels der Diode elektrisch verbunden sind,
- eine elektrische Ausgangsanschlußdose, mit
   -- einem Ausgangsanschlußdosenanordnungselement und
   -- einer Ausgangsanschlußdosenkontakteinrichtung mit zwei Leiterkontakten und zumindest einer Diode,
wobei zwei der elektrischen Leiter des Solarmoduls jeweils mit einem zugeordneten Leiterkontakt der Ausgangsanschlußdosenkontakteinrichtung kontaktiert sind,
wobei die zwei Leiterkontakte mittels der Diode elektrisch verbunden sind und wobei die Eingangsanschlußdose mittels des Eingangsanschlußdosenanordnungselements und die Ausgangsanschlußdose mittels des Ausgangsanschlußdosenanordnungselements voneinander beabstandet an dem Solarmodul angeordnet sind.

Das Solarmodul kann zumindest zwei in Reihe geschaltete spannungserzeugende Solarzellen bzw. Solarzellengruppen umfassen, wobei jede Solarzelle zwei elektrische Leiter aufweist, die den Plus- und Minuspol der Solarzelle bilden. Folglich umfaßt ein Solarmodul zumindest vier elektrische Leiter. Auf einer Anschlußseite sind die zumindest vier elektrischen Leiter in Form dünner Leiterbänder aus dem Solarmodul heraus geführt. Die
"Anschlußseite bzw. -fläche" im Sinne der Erfindung beschreibt eine Seite bzw. Fläche, die insbesondere einer lichtaktiven Seite bzw. Fläche gegenüber liegt. In anderen Worten ist die lichtaktive Seite bzw. Fläche ausgelegt, Licht aufzunehmen bzw. in das Solarmodul zu führen. Die "Anschlußseite bzw. -fläche" ist insbesondere die Rückseite des Solarmoduls, mittels welcher das Solarmodul beispielsweise angeordnet bzw. montiert werden kann.

Um die Solarzelle wie eingangs beschrieben zu schützen, sind der Plus- und Minuspol einer Solarzelle mittels einer Bypass-Diode miteinander verbunden, wobei die Bypass-Diode einen Kurzschluß zwischen den beiden Polen erzeugt, wenn die über die Solarzelle abfallende Spannung einen vorbestimmten Grenzwert überschreitet. Eine Bypass-Diode ist an der Eingangsanschlußdosenkontakteinrichtung der Eingangsanschlußdose angeordnet und verbindet mittelbar die elektrischen Leiter einer ersten Solarzelle, wobei die elektrischen Leiter mit zwei verschiedenen Leiterkontakten der Eingangsanschlußdosenkontakteinrichtung kontaktiert sind, die lediglich durch die Bypass-Diode miteinander elektrisch verbunden sind. Analog ist eine zweite Bypass-Diode an der Ausgangsanschlußdosenkontakteinrichtung der Ausgangsanschlußdose angeordnet und verbindet mittelbar die elektrischen Leiter einer zweiten Solarzelle, wobei die elektrischen Leiter der ersten Solarzelle von den elektrischen Leitern der zweiten Solarzelle verschieden sind. Die Solarzellen sind untereinander elektrisch leitend verbunden, wobei der Minuspol einer Solarzelle mit dem Pluspol einer weiteren Solarzelle verbunden sein kann.

Insbesondere ist genau eine Bypass-Diode in der Eingangsanschlußdose und genau eine Bypass-Diode in der Ausgangsanschlußdose angeordnet. Vorteilhafterweise kann die in der Eingangsanschlußdose bzw. in der Ausgangsanschlußdose anfallende thermische Energie beim Betrieb des Solarpaneels reduziert werden, so daß spezielle Maßnahmen zur Wärmeabfuhr vorteilhafterweise nicht notwendig sind.

Der Begriff "Kontakt" im Sinne der vorliegenden Erfindung beinhaltet insbesondere elektrischen und/oder mechanischen Kontakt, so daß eine Eingangs- bzw. Ausgangsanschlußdosenkontakteinrichtung ausgelegt ist einen elektrischen und/oder einen mechanischen Kontakt mit den elektrischen Leitern der Solarzelle herzustellen. Der Kontakt kann insbesondere durch Löten, Schweißen, Klemmen, Schrauben oder dergleichen hergestellt sein.

Die Leiterkontakte der Eingangs- bzw. Ausgangsanschlußdosenkontakteinrichtung sind insbesondere ausgelegt mit Leiterbändern zu kontaktieren. Mit anderen Worten umfassen die Leiterkontakte insbesondere einen im wesentlichen ebenen Bereich, der ausgelegt ist, im wesentlichen formschlüssig mit einem elektrischen Leiter, insbesondere einem Leiterband, zu kontaktieren.

Der Begriff "im wesentlichen" kann im Sinne der vorliegenden Erfindung eine Abweichung von einer gewünschten Eigenschaft beschreiben. Insbesondere kann dies eine geringe Abweichung, d.h. ohne signifikante Änderung der gewünschten Eigenschaft sein, beispielsweise, falls die gewünschte Eigenschaft als Solleigenschaft angesehen wird, kann "im wesentlichen" ein Abweichung von dieser Solleigenschaft um weniger als etwa 50%, weniger als etwa 30%, weniger als etwa 20%, weniger als etwa 10%, weniger als etwa 5%, weniger als etwa 2%, insbesondere weniger als etwa 1% beschreiben.

Die Eingangs- und Ausgangsanschlußdose sind an der Anschlußseite bzw. - fläche des Solarmoduls voneinander beabstandet angeordnet. Die Anordnung der Eingangs- bzw. Ausgangsanschlußdose erfolgt mittels des Eingangs- bzw. Ausgangsanschlußdosenanordnungselements, wobei das Eingangsanschlußdosenanordnungselement und/oder das Ausgangsanschlußdosenanordnungselement insbesondere dazu ausgelegt sein können, um mit dem Solarmodul verklebt zu sein.

Der Begriff "beabstandet" insbesondere in Bezug auf die Beabstandung der Eingangs- und Ausgangsanschlußdose beschreibt im Sinne der Erfindung, daß zwischen der Eingangsanschlußdose und der Ausgangsanschlußdose ein lichter Abstand von vorzugsweise mehr als etwa 1 cm, mehr als etwa 5 cm, mehr als etwa 10 cm, mehr als etwa 50 cm und besonders bevorzugt mehr als etwa 1 m besteht. Insbesondere beträgt der lichte Abstand von Ausgangsanschlußdose zu Ausgangsanschlußdose etwa 1 m, etwa 1,60 m oder etwa 2 m. Der Abstand wird durch die Abmessung des Solarmoduls begrenzt, da insbesondere die Eingangsanschlußdose und/oder die Ausgangsanschlußdose von dem Rand des Solarmoduls beabstandet angeordnet werden. Vorteilhafterweise sind die Eingangsanschlußdose und/oder die Ausgangsanschlußdose vollständig an der Anschlußseite bzw. Anschlußfläche angeordnet.

Die eine Eingangs- und Ausgangsanschlußdosenkontakteinrichtung sind über das Solarmodul miteinander elektrisch verbunden, wobei die Eingangs- und Ausgangsanschlußdosenkontakteinrichtung dadurch definiert sind, daß der elektrische Strom von der Eingangsanschlußdosenkontakteinrichtung in Richtung der Ausgangsanschlußdosenkontakteinrichtung fließt, wenn das Solarpaneel in betriebsmäßigem Gebrauch ist. In anderen Worten können die Eingangsanschlußdose und die Ausgangsanschlußdose die beiden Pole des Solarpaneels bilden, d.h. die Ausgangsanschlußdose kann der Pluspol sein und die Eingangsanschlußdose kann der Minuspol sein, so daß der Strom durch einen an das Solarpaneel angeschlossenen Verbraucher vom Pluspol zum Minuspol fließt. Die Terminologie kann auch umgedreht werden.

Vorteilhafterweise sind die Eingangs- und Ausgangsanschlußdosen einfach zu montieren und können unabhängig voneinander an beliebigen Stellen des Solarmoduls angeordnet werden. Dadurch ist es vorteilhafterweise möglich die Eingangsanschlußdose z.B. an einem zur Ausgangsanschlußdose entgegengesetzten Ende des Solarmoduls anzuordnen. Werden mehrere solcher Solarpaneele nebeneinander in einer Solaranlage installiert, kann eine Ausgangsanschlußdose eines ersten Solarpaneels benachbart zu einer Eingangsanschlußdose eines zweiten Solarpaneels angeordnet sein. Dadurch können die Kabelverbindungen zwischen den zwei Solarpaneelen vorteilhafterweise minimiert werden, wodurch sich eine Materialersparnis und eine Erleichterung der Montage der Solaranlage ergibt.

Da genau eine Diode in der Eingangsanschlußdose angeordnet ist und genau eine Diode in der Ausgangsanschlußdose angeordnet ist, wird vorteilhafterweise erreicht, daß die Abwärme der Diode effizient aus der entsprechenden Anschlußdose geleitet werden kann. Somit kann eine Beschädigung der Diode und/oder Anschlußdose aufgrund übermäßiger Wärme verhindert werden.

Die Leiterkontakte der Eingangsanschlußdose sind in betriebsmäßigem Gebrauch, d.h., wenn die Eingangsanschlußdose an dem Solarmodul angeordnet ist, voneinander mechanisch und elektrisch getrennte Elemente, die mittels der Diode zumindest elektrisch miteinander verbunden sind.

### Bevorzugte Ausführungsformen der Anschlußdose

Das Ausgangsanschlußdosenanordnungselement kann ein Ausgangsanschlußdosenbefestigungselement umfassen bzw. ein Ausgangsanschlußdosenbefestigungselement sein, wobei das Anordnen der Ausgangsanschlußdose bevorzugt ein Befestigen beinhalten kann. Entsprechend kann das Eingangsanschlußdosenanordnungselement ein Eingangsanschlußdosenbefestigungselement umfassen bzw. ein Eingangsanschlußdosenbefestigungselement sein, wobei das Anordnen der Eingangsanschlußdose ebenfalls bevorzugt ein Befestigen beinhalten kann.

Vorzugsweise weist die Eingangsanschlußdose genau einen elektrischen Verbinder mit einem Anschlußpol auf, der mit einem Anschlußpolkontakt der Eingangsanschlußdosenkontakteinrichtung kontaktiert ist. Weiter vorzugsweise weist die Ausgangsanschlußdose genau einen elektrischen Verbinder mit einem Anschlußpol auf, der mit einem Anschlußpolkontakt der Ausgangsanschlußdosenkontakteinrichtung kontaktiert ist.

Vorteilhafterweise kann die elektrische Kontaktierung des Solarpaneels mittels des oder der elektrischen Verbinder(s) besonders einfach hergestellt werden, wobei die Eingangsanschlußdose bzw. die Ausgangsanschlußdose kompakt ausgebildet werden kann. Ein Verbinder stellt lediglich jeweils einen Anschlußpol bereit, d.h. einen Pluspol oder einen Minuspol des Solarpaneels. Gemäß der Definition der Eingangs- und Ausgangsanschlußdosenkontakteinrichtung über die Stromflußrichtung, stellt die Ausgangsanschlußdose den Pluspol und die Eingangsanschlußdose den Minuspol bereit, wenn das Solarpaneel in betriebsmäßigem Gebrauch ist. Der Verbinder kann einstückig mit der Eingangs- und/oder Ausgangsanschlußdose ausgebildet sein. Beispielsweise kann die Eingangs- und/oder Ausgangsanschlußdose in einem Spritzgußverfahren hergestellt sein, wobei der Verbinder gleichzeitig mit hergestellt wird. Es ist auch möglich, daß die Eingangs- und/oder die Ausgangsanschlußdose und der Verbinder in getrennten Verfahrensschritten hergestellt werden und der Verbinder anschließend an der Eingangs- und/oder der Ausgangsanschlußdose angeordnet wird, beispielsweise daran festgeklebt wird.

Vorzugsweise weist die Eingangsanschlußdose genau ein Kabel mit genau einer Leitung bzw. einer Leitungsader auf, die mit einem Leitungskontakt bzw. einem Leitungsaderkontakt der Eingangsanschlußdosenkontakteinrichtung kontaktiert ist. Weiter vorzugsweise weist die Ausgangsanschlußdose genau ein Kabel mit genau einer Leitung bzw. einer Leitungsader auf, die mit einem Leitungskontakt bzw. einem Leitungsaderkontakt der Ausgangsanschlußdosenkontakteinrichtung kontaktiert ist.

Vorteilhafterweise kann die elektrische Kontaktierung des Solarpaneels mittels des oder der Kabel besonders betriebssicher hergestellt werden, wobei insbesondere eine erhöhte Feuchtigkeitsdichtigkeit in einfacher Weise erreicht werden kann. Hierbei kann eine Zugentlastung des Kabels fest mit der Eingangs- und/oder der Ausgangsanschlußdose verbunden, insbesondere verklebt sein. Analog zu der vorangehenden Beschreibung stellt ein Kabel lediglich jeweils einen Anschlußpol bereit, d.h. einen Pluspol oder einen Minuspol des Solarpaneels, so daß ein Kabel lediglich eine Leitung bzw. eine Leitungsader aufweist.

Besonders bevorzugt kann zur Kontaktierung bzw. zum Anschluß des Solarpaneels ein Verbinder und ein Kabel vorgesehen sein, wobei die Eingangsanschlußdose einen Verbinder und die Ausgangsanschlußdose ein Kabel aufweist. Alternativ kann die Eingangsanschlußdose ein Kabel und die Ausgangsanschlußdose einen Verbinder aufweisen. Insbesondere kann das Kabel an seinem zur Eingangs- bzw. Ausgangsdose distalen Ende weiter einen komplementären Verbinder aufweisen, der ausgelegt ist, mit dem Verbinder der Ausgangs- bzw. Eingangsdose eines zweiten Solarpaneels verbunden bzw. kontaktiert zu werden.

Vorzugsweise umfaßt das Solarpaneel weiter
zumindest eine elektrische Überbrückungsdose, mit
-- einem Überbrückungsdosenanordnungselement und
-- einer Überbrückungsdosenkontakteinrichtung mit zwei Leiterkontakten und zumindest einer Diode,
wobei zwei der elektrischen Leiter des Solarmoduls jeweils mit einem zugeordneten Leiterkontakt der Überbrückungsdosenkontakteinrichtung kontaktiert sind,
wobei die zwei Leiterkontakte mittels der Diode elektrisch verbunden sind und wobei die zumindest eine Überbrückungsdose mittels des Überbrückungsdosenanordnungselements von der Eingangsanschlußdose und der Ausgangsanschlußdose beabstandet an dem Solarmodul angeordnet ist.

Der lichte Abstand zwischen Ausgangsanschlußdose und Überbrückungsdose beträgt bevorzugt etwa 30 cm.

Vorzugsweise ist das Solarpaneel derart ausgebildet, daß das Eingangsanschlußdosenanordnungselement eine Eingangsanschlußdosenbefestigungswand und/oder das Ausgangsanschlußdosenanordnungselement eine Ausgangsanschlußdosenbefestigungswand und/oder das Überbrückungsdosenanordnungselement eine Überbrückungsdosenbefestigungswand aufweist. Vorteilhafterweise läßt sich das Solarpaneel in Massenproduktion dadurch einfach und zuverlässig mit den erforderlichen Anordnungselementen versehen. Dies wird in bevorzugter Weise weiter vereinfacht, wenn von der Eingangsanschlußdosenbefestigungswand und/oder von der Ausgangsanschlußdosenbefestigungswand und/oder von der Überbrückungsdosenbefestigungswand ein Befestigungsflansch abragt bzw. hervorragt. Jeder Befestigungsflansch kann in vorteilhafter Weise zumindest einen Kanal aufweisen. Dabei ist die Anzahl der jeweiligen Kanäle sowie deren Anordnung in dem Befestigungsflansch und Gestalt je nach Einsatzzweck beliebig anpaßbar.

Das Solarmodul kann zumindest zwei, d.h. 2, 3, 4, 5, 6, 7, 8, 9, 10, usw. in Reihe geschaltete spannungserzeugende Solarzellen bzw. Solarzellengruppen umfassen, wobei jede Solarzelle zwei elektrische Leiter aufweist, die den Plus- und Minuspol der Solarzelle bilden und die an der Anschlußseite des Solarmoduls aus diesem heraus geführt werden. Folglich umfaßt ein Solarmodul zumindest vier, d.h. 4, 6, 8, 10, 12, 14, 16, 18, 20, usw. elektrische Leiter, von denen zwei mit der Eingangsanschlußdose verbunden sind und zwei mit der Ausgangsanschlußdose verbunden sind.

Um die weiteren Solarzellen mittels einer Bypass-Diode zu schützen, sind der Plus- und Minuspol einer der weiteren, insbesondere jeder der weiteren, Solarzelle(n) mit jeweils einem Leiterkontakt der Überbrückungsdosenkontakteinrichtung kontaktiert. Die Bypass-Diode ist an der Überbrückungsdosenkontakteinrichtung der Überbrückungsdose angeordnet und verbindet mittelbar deren elektrische Leiter. Folglich ist die Anzahl der Dioden gleich der Anzahl der Dosen, d.h. der Summe aus Eingangsanschlußdose und Ausgangsanschlußdose und Überbrückungsdose(n).

Die Leiterkontakte der Überbrückungsdosenkontakteinrichtung sind insbesondere ausgelegt mit Leiterbändern zu kontaktieren. Mit anderen Worten umfassen die Leiterkontakte insbesondere einen im wesentlichen ebenen Bereich, der ausgelegt ist, im wesentlichen formschlüssig mit einem elektrischen Leiter, insbesondere einem Leiterband, zu kontaktieren. Die Überbrückungsdosen bzw. die Überbrückungsdosenkontakteinrichtung weist über die Leiterkontakte hinaus keine weiteren Kontakte auf, insbesondere keine weiteren Eingänge und/oder Ausgänge bzw. Anschlußpole, um die Überbrückungsdosenkontakteinrichtung mit einer externen Einrichtung elektrisch zu verbinden.

Eine oder mehrere Überbrückungsdose(n) sind an der Anschlußseite des Solarmoduls voneinander und von der Eingangs- und Ausgangsanschlußdose beabstandet angeordnet. Insbesondere ist/sind die Überbrückungsdose(n) entlang der Verbindungslinie zwischen der Eingangs- und Ausgangsanschlußdose angeordnet. Die Anordnung erfolgt mittels des jeweiligen Überbrückungsdosenanordnungselements, welches insbesondere dazu ausgelegt sein kann, um mit dem Solarmodul verklebt zu sein.

Vorzugsweise weist das Überbrückungsdosenanordnungselement ein an der Überbrückungsdosenkontakteinrichtung angeordnetes Haftmittel auf, wobei die Überbrückungsdosenkontakteinrichtung mittels des Haftmittels an dem Solarmodul befestigt ist.

Insbesondere kann das Überbrückungsdosenanordnungselement ein Überbrückungsdosenbefestigungselement aufweisen bzw. sein, welches eine Schicht Haftkleber, Schmelzkleber und/oder ein doppelseitiges Klebeband umfaßt. Vorteilhafterweise ist die Überbrückungsdose dadurch materialsparend und einfach an dem Solarmodul zu befestigen, da die Überbrückungsdose im wesentlichen grundplattenfrei, d.h. ohne eine Grundplatte bzw. Bodenplatte ausgebildet ist. Aufgrund der geringen mechanischen Belastung der Überbrückungsdose, die insbesondere keine Kabelanschlüsse umfaßt, so daß keine Zugbelastung auftritt, steht eine vereinfachte bzw. schwächere Befestigung der Überbrückungsdose einem sicheren Betrieb nicht entgegen.

Gemäß der vorbeschriebenen und/oder nachfolgenden Ausführungsform(en) kann das Überbrückungsdosenanordnungselement auch als Überbrückungsdosenbefestigungselement bezeichnet werden, wobei das Überbrückungsdosenbefestigungselement ein strukturelles Element der Überbrückungsdose ist und eine Schicht Haftkleber, Schmelzkleber und/oder ein doppelseitiges Klebeband umfassen. In anderen Worten können gemäß der vorbeschriebenen und/oder nachfolgenden Ausführungsform(en) die Begriffe Überbrückungsdosenanordnungselement und Überbrückungsdosenbefestigungselement synonym verwendet werden.

Vorzugsweise umfaßt das Eingangsanschlußdosenanordnungselement eine Eingangsanschlußdosengrundplatte. Weiter vorzugsweise umfaßt das Ausgangsanschlußdosenanordnungselement eine Ausgangsanschlußdosengrundplatte. Weiter vorzugsweise umfaßt das zumindest eine Überbrückungsdosenanordnungselement eine Überbrückungsdosengrundplatte.

Eine Eingangsanschlußdosengrundplatte und/oder Ausgangsanschlußdosengrundplatte und/oder Überbrückungsdosengrundplatte ist/sind besonders vorzugsweise dazu ausgelegt, um an dem Solarmodul angeordnet oder mit dem Solarmodul verklebt zu sein. Insbesondere ist die Seite der Dosengrundplatte, die an dem Solarmodul angeordnet bzw. befestigt wird, im wesentlichen eben ausgebildet. Insbesondere kann ein Haftmittel auf der Dosengrundplatte aufgetragen sein. Das Haftmittel kann beispielsweise einen Haftkleber und/oder einen Schmelzkleber und/oder ein Klebeband, usw. umfassen. Weiter vorzugsweise umfaßt eine Eingangsanschlußdosengrundplatte und/oder Ausgangsanschlußdosengrundplatte und/oder Überbrückungsdosengrundplatte zumindest einen Öffnungsbereich. Insbesondere kann jedem Leiterkontakt ein Öffnungsbereich zugeordnet sein.

Vorzugsweise weist die Eingangsanschlußdose einen Eingangsanschlußdosendeckel auf. Weiter vorzugsweise weist die Ausgangsanschlußdose einen Ausgangsanschlußdosendeckel auf. Weiter vorzugsweise weist die zumindest eine Überbrückungsdose einen Überbrückungsdosendeckel auf. Besonders bevorzugt weist/weisen der Eingangsanschlußdosendeckel und/oder der Ausgangsanschlußdosendeckel und/oder der zumindest eine Überbrückungsdosendeckel eine Einfüllöffnung auf.

Insbesondere ist die Einfüllöffnung dazu ausgelegt, eine Extrusionsdüse für flüssiges Kunstharz zu kontaktieren und/oder aufzunehmen. Dazu ist die Einfüllöffnung insbesondere kegelförmig ausgebildet.

Vorzugsweise ist das Innere der Eingangsanschlußdose und/oder das Innere der Ausgangsanschlußdose und/oder das Innere der zumindest einen Überbrückungsdose feuchtigkeitsdichtend mit einer Ausgießmasse ausgegossen, insbesondere, um die Eingangsanschlußdose und/oder die Ausgangsanschlußdose und/oder die zumindest eine Überbrückungsdose mittels der Ausgießmasse an dem Solarmodul zu befestigen.

Die Eingangsanschlußdose und/oder die Ausgangsanschlußdose und/oder die Überbrückungsdose ist/sind bevorzugt mit einer Ausgießmasse, vorzugsweise mit einem isolierenden Harz und/oder einem Kunststoff und/oder einem Polymer, insbesondere mit einem Polymerkleber, und/oder einem Elastomer, insbesondere mit einem Silikon, ausgegossen, um die einzelnen Bestandteile fest miteinander zu verbinden und elektrisch voneinander zu isolieren. Vorteilhafterweise ist durch das Ausgießen mit einem isolierenden Harz, Kunstharz, Polymer und/oder Elastomer ein besonders guter Schutz vor eindringender Feuchtigkeit, z.B. nach der standardisierten Norm IP67 zu erreichen.

Weiterhin kann die Ausgießmasse auch dazu dienen, die entsprechende Dose an dem Solarmodul zu befestigen, wenn z.B. die Ausgießmasse eine chemische und/oder mechanische Verbindung mit dem Solarmodul eingeht. In diesem Fall kann die Ausgießmasse bzw. das Kunstharz als Haftmittel dienen. Weiter bevorzugt erfolgt die Befestigung der entsprechenden Dose ausschließlich durch die Ausgießmasse. Die entsprechende Dose kann zumindest zeitweise an dem Solarmodul mechanisch fixiert bzw. gehalten sein, beispielsweise bis die Ausgießmasse bzw. das Kunstharz eine hinreichende Befestigung der entsprechenden Dose an dem Solarmodul ausbildet. Bevorzugt kann die entsprechende Dose auch durch zumindest ein weiteres Haftmittel zumindest zeitweise an dem Solarmodul befestigt bzw. fixiert sein, bis die entsprechende Dose mittels der Ausgießmasse an dem Solarmodul befestigt ist. Beispielsweise kann das Befestigen der entsprechenden Dose mit einem oder mehreren Klebemitteln an dem Solarmodul erfolgen. Dies gilt insbesondere für eine Überbrückungsdose, wenn die Überbrückungsdose grundplattenfrei ausgebildet ist. In diesem Fall kann die Überbrückungsdosenkontakteinrichtung an dem Solarmodul angeordnet werden und die Leiterkontakte mit den Leitern des Solarmoduls kontaktiert werden. Anschließend kann der Überbrückungsdosendeckel angeordnet werden und der somit gebildete Hohlraum mit Kunstharz ausgegossen werden, wodurch eine innige Verbindung zwischen dem Überbrückungsdosendeckel und dem Kunstharz und der Fläche des Solarmoduls herstellbar ist, wobei die Überbrückungsdosenkontakteinrichtung in das Kunstharz eingebettet ist. Somit besteht das Gehäuse der Überbrückungsdose im wesentlichen aus dem Überbrückungsdosendeckel, wobei eine Seite der Überbrückungsdose durch das Solarmodul verschlossen ist.

Vorzugsweise weist die Eingangsanschlußdosenkontakteinrichtung zwei Leiterkontakte auf, welche mittels der Diode mechanisch miteinander verbunden sind. Weiter vorzugsweise weist die Ausgangsanschlußdosenkontakteinrichtung und/oder die zumindest eine Überbrückungsdosenkontakteinrichtung zwei Leiterkontakte auf, welche mittels der Diode mechanisch miteinander verbunden sind.

Dabei sind die zwei Leiterkontakte insbesondere derart mit der Diode verbunden, daß die Position der zwei Leiterkontakte zueinander durch die Diode fixiert ist. Die Verbindung zwischen der Diode und dem jeweiligen Leiterkontakt kann durch Schweißen, Löten, Kleben, Verkrimpen, usw. erfolgen.

Vorzugsweise ist der Anschlußpolkontakt oder der Leitungskontakt bzw. Leitungsaderkontakt der Eingangsanschlußdosenkontakteinrichtung mit einem der Leiterkontakte einstückig ausgebildet. Insbesondere besteht der Leiterkontakt aus einem Metallblech bzw. bestehen der Leiterkontakt und der Anschlußpolkontakt oder der Leitungskontakt bzw. der Leitungsaderkontakt der Eingangsanschlußdosenkontakteinrichtung aus einem gemeinsamen Stück Metallblech.

Weiter vorzugsweise ist der Anschlußpolkontakt oder der Leitungskontakt der Ausgangsanschlußdosenkontakteinrichtung mit einem der Leiterkontakte einstückig ausgebildet. Insbesondere besteht der Leiterkontakt aus einem Metallblech bzw. bestehen der Leiterkontakt und der Anschlußpolkontakt oder der Leitungskontakt der Ausgangsanschlußdosenkontakteinrichtung aus einem gemeinsamen Stück Metallblech.

Vorzugsweise ist die Diode eine SMD-Diode. Vorteilhafterweise ist aufgrund der flachen Bauweise der SMD-Diode ein verbesserter mechanischer Kontakt zwischen dem Leiterkontakt und der Diode ausgebildet. Weiter vorteilhafterweise ist der spezifische Wärmefluß aufgrund der vergrößerten Oberfläche der SMD-Diode gegenüber einer zylindrischen Koaxial-Diode bei gleicher Verlustleistung verringert, so daß die von der Diode ausgehende thermische Belastung der umliegenden Bauteile verringert ist.

### Herstellungsverfahren gemäß einem Aspekt

Ein Aspekt der vorliegenden Erfindung betrifft ein Verfahren zum Herstellen eines Solarpaneels, umfassend die Schritte:
- Bereitstellen eines Solarmoduls mit zumindest vier elektrischen Leitern,
- Bereitstellen einer elektrischen Eingangsanschlußdose mit
   -- einem Eingangsanschlußdosenanordnungselement und
   -- einer Eingangsanschlußdosenkontakteinrichtung mit zwei Leiterkontakten und zumindest einer Diode, welche die zwei Leiterkontakte elektrisch verbindet,
- Anordnen der Eingangsanschlußdose an dem Solarmodul, wobei zwei der elektrischen Leiter des Solarmoduls jeweils mit einem zugeordneten Leiterkontakt der Eingangsanschlußdosenkontakteinrichtung kontaktiert werden,
- Bereitstellen einer elektrischen Ausgangsanschlußdose, mit
   -- einem Ausgangsanschlußdosenanordnungselement und
   -- einer Ausgangsanschlußdosenkontakteinrichtung mit zwei Leiterkontakten und zumindest einer Diode, welche die zwei Leiterkontakte elektrisch verbindet,
- Anordnen der Ausgangsanschlußdose an dem Solarmodul, wobei zwei der elektrischen Leiter des Solarmoduls jeweils mit einem zugeordneten Leiterkontakt der Ausgangsanschlußdosenkontakteinrichtung kontaktiert werden,
wobei die Eingangsanschlußdose mittels des Eingangsanschlußdosenanordnungselements und die Ausgangsanschlußdose mittels des Ausgangsanschlußdosenanordnungselements voneinander beabstandet an dem Solarmodul angeordnet werden.

Das Ausgangsanschlußdosenanordnungselement kann ein Ausgangsanschlußdosenbefestigungselement umfassen bzw. ein Ausgangsanschlußdosenbefestigungselement sein, wobei das Anordnen der Ausgangsanschlußdose bevorzugt ein Befestigen beinhalten kann. Entsprechend kann das Eingangsanschlußdosenanordnungselement ein Eingangsanschlußdosenbefestigungselement umfassen bzw. ein Eingangsanschlußdosenbefestigungselement sein, wobei das Anordnen der Eingangsanschlußdose ebenfalls bevorzugt ein Befestigen beinhalten kann. Das Befestigen der Eingangs- bzw. Ausgangsanschlußdose kann insbesondere mittels eines Klebemittels erfolgen. Das Befestigen kann beispielsweise ein Auftragen, insbesondere ein Aufsprühen eines verformbaren, insbesondere flüssigen Klebers an bzw. auf einer Kontaktfläche der Eingangs- und/oder Ausgangsanschlußdose umfassen, mit welcher die Eingangs- und/oder Ausgangsanschlußdose mit dem Solarmodul in Kontakt tritt. Der Kleber kann beispielsweise die Kontaktfläche vollständig bedecken. Es ist auch möglich, daß der Kleber lediglich an diskreten Punkten bzw. Flächen auf. bzw. an der Kontaktfläche aufgetragen ist. Weiter bevorzugt kann die Kontaktfläche mittels einer Coronabehandlung vorbereitet sein, um eine verbesserte Verbindung der Eingangsanschlußdose und/oder der Ausgangsanschlußdose mit dem Solarmodul zu erreichen.

Weiterhin kann das Befestigen der entsprechenden Dose an dem Solarmodul beinhalten, daß der Kleber seine klebende bzw. haftende Eigenschaft erhält. Der Kleber kann z.B. mit Wärme und/oder mit Licht behandelt werden, wie z.B. mit UV Licht bestrahlt werden.
Die vorangehenden Ausführungen gelten sinngemäß, falls der Kleber an bzw. auf der Kontaktfläche des Solarmoduls angeordnet ist. Der Kleber kann beispielsweise ein sogenannter Zwei-Komponentenkleber sein, wobei eine Komponente an der Eingangs- und/oder Ausgangsanschlußdose angeordnet ist und eine weitere Komponente an dem Solarmodul. Das Befestigen kann somit beinhalten, daß die beiden Komponenten miteinander in Kontakt gebracht werden. Alternativ oder zusätzlich kann das Befestigen auch umfassen, daß eine Schutzfolie von einem Haft- bzw. Klebemittel entfernt wird.

Das Befestigen im Sinne der Erfindung kann vorzugsweise auch durch das Kontaktieren der elektrischen Leiter des Solarmoduls mit den zugeordneten Leiterkontakten der Eingangsanschlußdosenkontakteinrichtung bzw. der Ausgangsanschlußdosenkontakteinrichtung erfolgen, beispielsweise durch Verlöten, Vernieten, Verschrauben usw. In diesem Sinne stellen die Leiterkontakte auch ein Eingangsanschlußdosenanordnungselement bzw. ein Eingangsanschlußdosenbefestigungselement dar oder entsprechend ein Ausgangsanschlußdosenanordnungselement bzw. ein Ausgangsanschlußdosenbefestigungselement dar. Bevorzugt kann ein Befestigen der Eingangsanschlußdose bzw. der Ausgangsanschlußdose an dem Solarmodul, insbesondere mittels des Klebemittels, zeitlich vor oder nach dem Kontaktieren der elektrischen Leiter des Solarmoduls mit den zugeordneten Leiterkontakten erfolgen. Das Befestigen der Eingangs- bzw. Ausgangsanschlußdose an dem Solarmodul und das Kontaktieren der elektrischen Leiter des Solarmoduls mit den zugeordneten Leiterkontakten der Eingangs- bzw. Ausgangsanschlußdosenkontakteinrichtung können also unterschiedliche und zeitlich voneinander getrennte Verfahrensschritte sein. Vorteilhafterweise ermöglicht eine Befestigung der Eingangsanschlußdose bzw. der Ausgangsanschlußdose an dem Solarmodul vor dem elektrischen Kontaktieren eine einfachere Montage, da die Eingangsanschlußdose bzw. die Ausgangsanschlußdose sich nicht mehr relativ zu dem Solarmodul bewegen kann.

### Bevorzugte Ausführungsvarianten des Verfahrens

Vorzugsweise umfaßt das Verfahren die Schritte:
- Bereitstellen zumindest einer elektrischen Überbrückungsdose, mit
   -- einem Überbrückungsdosenanordnungselement und
   -- einer Überbrückungsdosenkontakteinrichtung mit zwei Leiterkontakten und zumindest einer Diode, welche die zwei Leiterkontakte elektrisch verbindet,
- Anordnen der Überbrückungsdose mittels des Überbrückungsdosenanordnungselements an dem Solarmodul, wobei zwei der elektrischen Leiter des Solarmoduls jeweils mit einem zugeordneten Leiterkontakt der Überbrückungsdosenkontakteinrichtung kontaktiert werden und
wobei die zumindest eine Überbrückungsdose von der Eingangsanschlußdose und der Ausgangsanschlußdose beabstandet an dem Solarmodul angeordnet wird.

Das Überbrückungsdosenanordnungselement kann ein Überbrückungsdosenbefestigungselement umfassen bzw. ein Überbrückungsdosenbefestigungselement sein, wobei das Anordnen der Überbrückungsdose bevorzugt ein Befestigen beinhalten kann. Das Befestigen der Überbrückungsdose kann ebenfalls insbesondere mittels eines Klebemittels erfolgen, wobei die Ausführen zum "Befestigen" in Zusammenhang mit der Eingangs- bzw. Ausgangsanschlußdose analog gelten.

Vorzugsweise umfaßt das Überbrückungsdosenanordnungselement ein an der Überbrückungsdosenkontakteinrichtung angeordnetes Haftmittel, wobei die Überbrückungsdosenkontakteinrichtung mittels des Haftmittels an dem Solarmodul befestigt wird. Insbesondere ist das Überbrückungsdosenanordnungselement ein an der Überbrückungsdosenkontakteinrichtung angeordnetes Haftmittel bzw. kann das Überbrückungsdosenanordnungselement ein Haftmittel als bevorzugtes Überbrückungsdosenbefestigungselement umfassen.

Vorzugsweise umfaßt das Verfahren die Schritte:
- Anordnen eines Eingangsanschlußdosendeckels an der Eingangsanschlußdose und/oder
- Anordnen eines Ausgangsanschlußdosendeckels an der Ausgangsanschlußdose und/oder
- Anordnen jeweils eines Überbrückungsdosendeckels an jeder Überbrückungsdose.

Bevorzugt umfaßt das obige Anordnen ebenfalls ein im wesentlichen fluiddichtes, insbesondere wasserdichtes und/oder luftdichtes, Verschließen.

Vorzugsweise umfaßt das Verfahren den Schritt des Trennens der Eingangsanschlußdosenkontakteinrichtung und/oder der Ausgangsanschlußdosenkontakteinrichtung und/oder der zumindest einen Überbrückungsdosenkontakteinrichtung an einer Sollbruchstelle.

Bevorzugt sind die zwei Leiterkontakte der Eingangsanschlußdosenkontakteinrichtung und/oder der Ausgangsanschlußdosenkontakteinrichtung und/oder der Überbrückungsdosenkontakteinrichtung in einem ursprünglichen Zustand zusammen einstückig ausgebildet, wobei die Eingangsanschlußdosenkontakteinrichtung eine Sollbruchstelle aufweist und/oder die Ausgangsanschlußdosenkontakteinrichtung eine Sollbruchstelle aufweist und/oder die Überbrückungsdosenkontakteinrichtung eine Sollbruchstelle aufweist/aufweisen, um die zwei Leiterkontakte zu dekontaktieren. Vorzugsweise werden die zwei Leiterkontakte vor dem Dekontaktieren derart mit der Diode verlötet, daß die Position der zwei Leiterkontakte zueinander nach dem Dekontaktieren durch die Diode fixiert ist. Durch das Trennen an der Sollbruchstelle erfolgt das Dekontaktieren, wobei sowohl der elektrische als auch der mechanische Kontakt unterbrochen wird.

Das Trennen kann mittels eines Werkzeugs vor oder nach dem Befestigen der Eingangsanschluß-/Ausgangsanschluß-/Überbrückungsdosenkontakteinrichtung an dem Solarmodul erfolgen. Bevorzugt kann das Trennen mittels des Eingangsanschluß-/Ausgangsanschluß-/Überbrückungsdosendeckels bzw. einer daran Angeordneten Trenneinrichtung mit dem Anordnen des Deckels erfolgen. Insbesondere ist es möglich, daß ein Element des Deckels beim Anordnen des Deckels an der entsprechenden Dose die Leiterkontakte an der Sollbruchstelle trennt und/oder an der Position der Sollbruchstelle zwischen den beiden Leiterkontakten angeordnet ist, um ein nachträgliches Kontaktieren der beiden Leiterkontakte zu verhindern.

Vorzugsweise umfaßt das Verfahren den Schritt: Ausgießen des Inneren der Eingangsanschlußdose und/oder der Ausgangsanschlußdose und/oder der zumindest einen Überbrückungsdose mit Kunstharz. Insbesondere kann die Eingangsanschlußdose und/oder die Ausgangsanschlußdose und/oder die zumindest eine Überbrückungsdose mittels der Ausgießmasse an dem Solarmodul zu befestigt sein.

Bevorzugt erfolgt das Ausgießen der Eingangsanschlußdose und/oder der Ausgangsanschlußdose und/oder der zumindest einen Überbrückungsdose durch die Öffnung des entsprechenden Deckels. Weiter bevorzugt umfaßt das Ausgießen das im wesentlichen fluiddichte, insbesondere wasserdichte und/oder luftdichte, Abdichten bzw. Verschließen des Inneren der Eingangsanschlußdose und/oder der Ausgangsanschlußdose und/oder der Überbrückungsdose. Die Bypass-Dioden und die damit verbunden elektrischen Leiter sind dadurch vorteilhafterweise vor Umwelteinflüssen, insbesondere vor Feuchtigkeit, geschützt. Weiter bevorzugt umfaßt das Ausgießen ebenfalls die Befestigung auf dem Solarmodul. Besonders bevorzugt umfaßt das Ausgießen auch die Befestigung von einem oder mehreren Bauteilen der Eingangsanschlußdose und/oder der Ausgangsanschlußdose und/oder der zumindest einen Überbrückungsdose untereinander oder mit einem oder mehreren Bauteilen des Solarmoduls. Insbesondere kann durch das Ausgießen eine Verbindung zwischen der Eingangsanschlußdose und/oder der Ausgangsanschlußdose und/oder der zumindest einen Überbrückungsdose und dem Solarmodul hergestellt werden, wobei der Teil der Eingangsanschlußdose, welcher durch die Ausgießmasse kontaktiert wird, als Eingangsanschlußdosenbefestigungeinrichtung bzw. als Eingangsanschlußdosenbefestigungelement angesehen werden kann. Dementsprechend kann der Teil der Ausgangsanschlußdose, welcher durch die Ausgießmasse kontaktiert wird, als Ausgangsanschlußdosenbefestigungeinrichtung bzw. als Ausgangsanschlußdosenbefestigungelement und der Teil der Überbrückungsdose, welcher durch die Ausgießmasse kontaktiert wird, als Überbrückungsdosenbefestigungeinrichtung bzw. als Überbrückungsdosenbefestigungelement angesehen werden.

Insbesondere können die elektrischen Leiter des Solarmoduls mit den zugeordneten Leiterkontakten der Eingangsanschlußdosenkontakteinrichtung bzw. der Ausgangsanschlußdosenkontakteinrichtung kontaktiert sein, während die Eingangsanschlußdose bzw. der Ausgangsanschlußdose lediglich an dem Solarmodul gehalten ist. Das Ausgießen der Eingangsanschlußdose bzw. der Ausgangsanschlußdose kann bevorzugt die Befestigung der Eingangsanschlußdose bzw. der Ausgangsanschlußdose an dem Solarmodul bewirken, wobei besonders bevorzugt auch eine Befestigung der elektrischen Leiter des Solarmoduls mit den zugeordneten Leiterkontakten der Eingangsanschlußdosenkontakteinrichtung bzw. der Ausgangsanschlußdosenkontakteinrichtung erfolgen kann.

Mit anderen Worten kann ein Herstellungsverfahren folgende Schritte umfassen:
- Bereitstellen eines Solarmoduls mit zumindest vier elektrischen Leitern,
- Bereitstellen einer elektrischen Eingangsanschlußdose mit
   -- einem eine Eingangsanschlußdosenbefestigungswand aufweisenden Eingangsanschlußdosenanordnungselement und
   -- einer Eingangsanschlußdosenkontakteinrichtung mit zwei Leiterkontakten und zumindest einer Diode, welche die zwei Leiterkontakte elektrisch verbindet,
   wobei zwei der elektrischen Leiter des Solarmoduls jeweils mit einem zugeordneten Leiterkontakt der Eingangsanschlußdosenkontakteinrichtung kontaktiert werden,
- Bereitstellen einer elektrischen Ausgangsanschlußdose, mit
   -- einem eine Ausgangsanschlußdosenbefestigungswand aufweisenden Ausgangsanschlußdosenanordnungselement und
   -- einer Ausgangsanschlußdosenkontakteinrichtung mit zwei Leiterkontakten und zumindest einer Diode, welche die zwei Leiterkontakte elektrisch verbindet,
   wobei zwei der elektrischen Leiter des Solarmoduls jeweils mit einem zugeordneten Leiterkontakt der Ausgangsanschlußdosenkontakteinrichtung kontaktiert werden,
- Ausgießen des Inneren der Eingangsanschlußdose und/oder der Ausgangsanschlußdose, wobei die Eingangsanschlußdose mittels des Eingangsanschlußdosenanordnungselements und/oder die Ausgangsanschlußdose mittels des Ausgangsanschlußdosenanordnungselements voneinander beabstandet an dem Solarmodul angeordnet bzw. befestigt werden.

Aufgrund dieses Verfahrens ist es vorteilhafterweise möglich, die Eingangsanschlußdose und die Ausgangsanschlußdose mittels Ausgießens an dem Solarpaneel zu befestigen, wobei gleichzeitig die elektrischen Funktionsteile gehalten, gesichert und geschützt werden können. Die Eingangsanschlußdosenbefestigungswand bzw. die Ausgangsanschlußdosenbefestigungswand sind vorteilhafterweise ausgelegt die Ausgießmasse bis zum Erhärten zu lokalisieren. Daher können Bereiche der Eingangsanschlußdosenbefestigungswand bzw. der Ausgangsanschlußdosenbefestigungswand, welche mit der Ausgießmasse kontaktieren auch als Eingangsanschlußdosenbefestigungeinrichtung bzw. Ausgangsanschlußdosenbefestigungeinrichtung bezeichnet werden.

Die zuvor genannten Vorteile gelten sinngemäß auch, wenn das Verfahren vorzugsweise die folgenden zusätzlichen Schritte umfaßt:
- Bereitstellen zumindest einer elektrischen Überbrückungsdose, mit
   -- einem eine Überbrückungsdosenbefestigungswand aufweisenden Überbrückungsdosenanordnungselement und
   -- einer Überbrückungsdosenkontakteinrichtung mit zwei Leiterkontakten und zumindest einer Diode, welche die zwei Leiterkontakten elektrisch verbindet,
   wobei zwei der elektrischen Leiter des Solarmoduls jeweils mit einem zugeordneten Leiterkontakt der Überbrückungsdosenkontakteinrichtung kontaktiert werden, und
- Ausgießen des Inneren der Überbrückungsdose(n), wobei die zumindest eine Überbrückungsdose von der Eingangsanschlußdose und der Ausgangsanschlußdose beabstandet an dem Solarmodul befestigt wird.

Schließlich kann in vorteilhafter Weise vorgesehen sein, daß vor dem Ausgießen des Inneren der Eingangsanschlußdose und/oder der Ausgangsanschlußdose und/oder der Überbrückungsdose jeweils ein Deckel aufgesetzt wird. Mit anderen Worten kann vorgesehen sein, vor dem Ausgießen der Eingangsanschlußdose und/oder der Ausgangsanschlußdose und/oder der Überbrückungsdose jeweils einen zugeordneten Deckel für die genannten Dosen vorzusehen. Vorteilhafterweise sind die befestigten bzw. von der Füllmasse ausgefüllten Teile dann zusätzlich durch einen Deckel gegen Umwelteinflüsse und Fremdeinwirkung geschützt. Bevorzugt sind zum Ausfüllen der jeweiligen Dosen zumindest eine Öffnung in jedem der Deckel vorgesehen.

### Anschlußdose gemäß einem Beispiel

Eine beispielhafte Anschlußdose, umfaßt:
- ein Anschlußdosenanordnungselement,
- eine Anschlußdosenkontakteinrichtung mit:
   -- zwei Leiterkontakten,
   -- genau einem Anschlußpolkontakt oder genau einem Leitungskontakt und
   -- zumindest einer Diode, welche die zwei Leiterkontakte elektrisch verbindet,
- genau einen Verbinder mit einem Anschlußpol, der mit dem Anschlußpolkontakt kontaktiert ist, oder
- genau ein mit der Anschlußdose verbundenes Kabel, dessen genau eine Leitungsader mit dem Leitungskontakt kontaktiert ist.

Je nach Verwendung der Anschlußdose entspricht die Anschlußdose einer oben beschriebenen Eingangsanschlußdose oder Ausgangsanschlußdose, das Anschlußdosenanordnungselement dem Eingangsanschlußdosenanordnungselement oder dem Ausgangsanschlußdosenanordnungselement und die Anschlußdosenkontakteinrichtung der Eingangsanschlußdosenkontakteinrichtung oder der Ausgangsanschlußdosenkontakteinrichtung. Die oben beschriebenen Eigenschaften gelten analog für die Anschlußdose. Ferner gelten die im folgenden beschriebenen Eigenschaften ebenfalls für die Eingangsanschlußdose und/oder die Ausgangsanschlußdose.

Vorzugsweise weist die Anschlußdose eine Anschlußdosenbefestigungswand auf. Hierdurch läßt sich die Anschlußdose in Massenproduktion einfach und zuverlässig herstellen und an dem Solarpaneel befestigen. Dies wird in bevorzugter Weise weiter vereinfacht, wenn von der Anschlußdosenbefestigungswand ein Befestigungsflansch abragt bzw. hervorragt. Der Befestigungsflansch kann in vorteilhafter Weise zumindest einen Kanal aufweisen. Dabei ist die Anzahl der jeweiligen Kanäle sowie deren Anordnung in dem Befestigungsflansch und Gestalt je nach Einsatzzweck beliebig anpaßbar.

Vorzugsweise umfaßt das Anschlußdosenanordnungselement eine Anschlußdosengrundplatte. Bevorzugt ist die Anschlußdosengrundplatte einstückig, insbesondere aus einem Polymer bzw. einem elektrisch nicht leitenden Kunststoff, ausgebildet.

Vorzugsweise weist die Anschlußdose einen Anschlußdosendeckel mit einer Einfüllöffnung auf.

Vorzugsweise sind die zwei Leiterkontakte der Anschlußdosenkontakteinrichtung einstückig ausgebildet, wobei die Anschlußdosenkontakteinrichtung eine Sollbruchstelle aufweist, um die zwei Leiterkontakte zu dekontaktieren. Weiterhin vorzugsweise kann die Anschlußdosenkontakteinrichtung beispielsweise aus einem Metall oder einer Metallegierung ausgebildet sein.

Vorzugsweise ist die Diode der Anschlußdosenkontakteinrichtung eine SMD-Diode.

### Überbrückungsdose gemäß einem Aspekt

Ein Aspekt der vorliegenden Erfindung betrifft eine Überbrückungsdose, umfassend:
- ein Überbrückungsdosenanordnungselement,
- eine Überbrückungsdosenkontakteinrichtung mit
   -- zwei Leiterkontakten und
   -- zumindest einer Diode, welche die zwei Leiterkontakte elektrisch verbindet.

Vorzugsweise weist die Überbrückungsdose eine Überbrückungsdosenbefestigungswand auf. Hierdurch läßt sich die Überbrückungsdose in Massenproduktion einfach und zuverlässig herstellen und an dem Solarpaneel befestigen. Dies wird in bevorzugter Weise weiter vereinfacht, wenn von der Überbrückungsdosenbefestigungswand ein Befestigungsflansch abragt. Der Befestigungsflansch kann in vorteilhafter Weise zumindest einen Kanal aufweisen. Dabei ist die Anzahl der jeweiligen Kanäle sowie deren Anordnung in dem Befestigungsflansch und Gestalt je nach Einsatzzweck beliebig anpaßbar.

Vorzugsweise umfaßt das Überbrückungsdosenanordnungselement ein an der Überbrückungsdosenkontakteinrichtung angeordnetes Haftmittel, wobei die Überbrückungsdosenkontakteinrichtung mittels des Haftmittels an einem Solarmodul befestigbar ist. Insbesondere ist das Überbrückungsdosenanordnungselement ein Haftmittel, das direkt an der Überbrückungsdosenkontakteinrichtung angeordnet ist. Das an dem Überbrückungsdosenanordnungselement angeordnete Haftmittel kann auch als Überbrückungsdosenbefestigungselement bezeichnet werden. Alternativ könnte auch das mit dem Haftmittel versehene Überbrückungsdosenanordnungselement als Überbrückungsdosenbefestigungselement bezeichnet werden. Beispielsweise ist die Überbrückungsdose grundplattenfrei, d.h., daß die Überbrückungsdose keine Grundplatte aufweist. Somit kann an dem Solarmodul die Überbrückungsdosenkontakteinrichtung angeordnet sein, und die Überbrückungsdosenkontakteinrichtung von einem Überbrückungsdosendeckel bedeckt sein.

Vorzugsweise umfaßt das Überbrückungsdosenanordnungselement eine Überbrückungsdosengrundplatte. Beispielsweise ist an der Überbrückungsdosengrundplatte das Haftmittel angeordnet.

Vorzugsweise weist die Überbrückungsdose einen Überbrückungsdosendeckel mit einer Einfüllöffnung auf.

Vorzugsweise sind die zwei Leiterkontakte der Überbrückungsdosenkontakteinrichtung zusammen einstückig ausgebildet, wobei die Überbrückungsdosenkontakteinrichtung eine Sollbruchstelle aufweist, um die zwei Leiterkontakte zu dekontaktieren.

Vorzugsweise ist die Diode der Überbrückungsdosenkontakteinrichtung eine SMD-Diode.

### Verwendung gemäß einem Aspekt

Ein Aspekt der vorliegenden Erfindung betrifft die Verwendung einer Anschlußdose mit den oben beschriebenen Merkmalen, zur Anordnung an einem Solarmodul als Eingangs- oder Ausgangsanschlußdose. Dabei wird die Anschlußdose an einer Anschlußseite des Solarmoduls angeordnet. Insbesondere kann danach die Anschlußdose mit dem Solarmodul elektrisch verbunden werden. Weiterhin kann die Anschlußdose verwendet werden, um das Solarmodul mit weiteren Solarmodulen oder elektrischen Verbrauchern zu verbinden.

Die Erfindung ist nicht auf die oben beschriebenen Aspekte bzw. Ausführungsformen beschränkt. Vielmehr können einzelne Merkmale der Aspekte und/oder Ausführungsformen beliebig miteinander kombiniert werden und insbesondere somit neue Ausführungsformen gebildet werden. In anderen Worten gelten die obigen Ausführungen zu den einzelnen Merkmalen der Vorrichtung sinngemäß auch für das Verfahren und umgekehrt.

### Figurenbeschreibung

Nachfolgend werden bevorzugte Ausführungsformen der vorliegenden Erfindung anhand der beigefügten Zeichnungen beispielhaft erläutert. Es zeigt:
Figur 1: eine perspektivische Ansicht einer bevorzugten Ausführungsform eines Solarpaneels in teilbestücktem Zustand;
Figur 2: eine Draufsicht auf eine bevorzugte Ausführungsform des Solarpaneels;
Figur 3: eine perspektivische Explosionsansicht einer bevorzugten Ausführungsform einer Eingangsanschlußdose;
Figur 4: eine perspektivische Explosionsansicht einer bevorzugten Ausführungsform einer Ausgangsanschlußdose;
Figur 5: eine perspektivische Explosionsansicht einer bevorzugten Ausführungsform einer Überbrückungsdose; und
Figur 6: eine perspektivische Ansicht einer bevorzugten Ausführungsform einer Überbrückungsdosenkontakteinrichtung;
Figur 7: eine perspektivische Explosionsansicht einer weiteren bevorzugten Ausführungsform einer Eingangsanschlußdose;
Figur 8: eine perspektivische Explosionsansicht einer weiteren bevorzugten Ausführungsform einer Ausgangsanschlußdose; und
Figur 9: eine perspektivische Explosionsansicht einer bevorzugten Ausführungsform einer Überbrückungsdose.

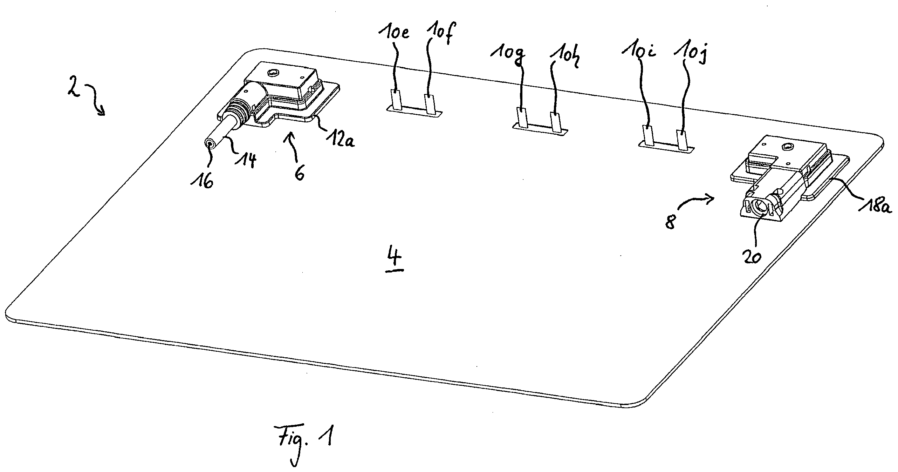

**Figur 1** zeigt eine perspektivische Ansicht einer bevorzugten Ausführungsform eines Solarpaneels 2 in teilbestücktem Zustand. Das gezeigt Solarpaneel 2 umfaßt ein Solarmodul 4, eine Eingangsanschlußdose 6 und eine Ausgangsanschlußdose 8.

Das Solarmodul 4 weist zehn elektrische Leiter 10a - 10j auf, die auf der Anschlußseite des Solarmoduls aus diesem heraus geführt sind. Zwei der elektrischen Leiter 10a, 10b (in Fig.1 nicht sichtbar) sind mit der bereits befestigten Eingangsanschlußdose 6 und zwei der elektrischen Leiter 10c, 10d (in Fig.1 nicht sichtbar) sind mit der bereits befestigten Ausgangsanschlußdose 8 kontaktiert. Sechs weitere elektrischen Leiter 10e - 10j ragen aus dem Solarmodul hervor und sind noch durch Überbrückungsdosen (nicht gezeigt) zu kontaktieren.

Die Eingangsanschlußdose 6 ist in dieser Ausführungsform mit ihrer Eingangsanschlußdosengrundplatte 12a als bevorzugtem Eingangsanschlußdosenanordnungselement 12 mit dem Solarmodul 4 verklebt. Die Eingangsanschlußdose 6 weist ein Kabel 14 mit genau einer Leitung 16 auf, welches mit der Eingangsanschlußdose 6 fest verbunden ist.

Die Ausgangsanschlußdose 8 ist in dieser Ausführungsform mit ihrer Ausgangsanschlußdosengrundplatte 18a als bevorzugtem Ausgangsanschlußdosenanordnungselement 18 mit dem Solarmodul 4 verklebt. Die Ausgangsanschlußdose 8 weist einen Verbinder 20 mit genau einem Anschlußpol auf. Weiterhin kann eine Fixierungsvorrichtung (nicht gezeigt) angeordnet sein, die dazu dient, das Kabel 14 z.B. während der Montage des Solarpaneels 2 und/oder während des Transport des Solarpaneels 2 zu fixieren, so daß verhindert wird, daß ein loses Ende des Kabels 14 das Solarpaneel 2 und/oder andere Gegenstände beschädigt bzw. Personen verletzt.

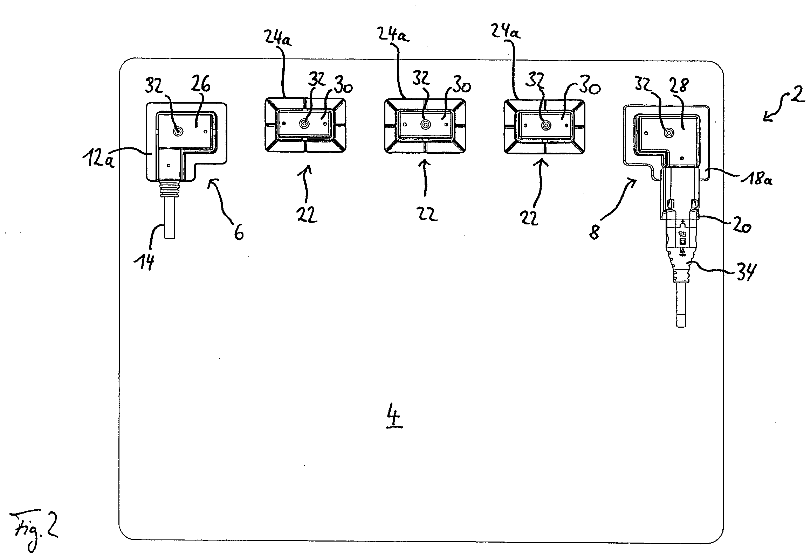

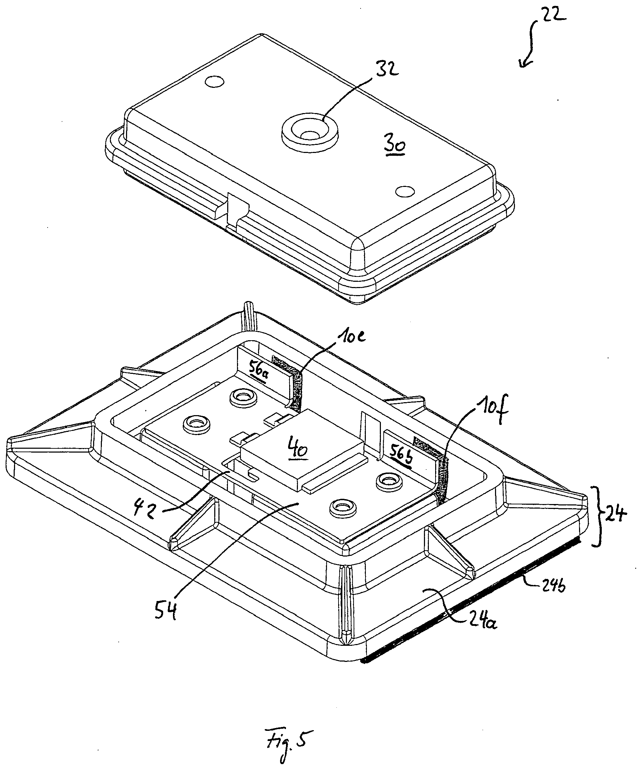

**Figur 2** zeigt eine Draufsicht auf eine bevorzugte Ausführungsform des Solarpaneels 2, mit drei Überbrückungsdosen 22, die jeweils mit ihrer Überbrückungsdosengrundplatte 24a als bevorzugtem Überbrückungsdosenanordnungselement 24 mit dem Solarmodul 4 verklebt sind. In den Überbrückungsdosen 22 wurden die elektrischen Leiter 10e - 10j (gezeigt in Figur 1) mit den entsprechenden Leiterkontakten (gezeigt in Figur 5) der Überbrückungsdosen 22 kontaktiert, insbesondere verlötet.

Figur 2 zeigt, daß die Eingangsanschlußdose 6 mittels eines Eingangsanschlußdosendeckels 26, die Ausgangsanschlußdose 8 mittels eines Ausgangsanschlußdosendeckels 28 und die Überbrückungsdosen 22 jeweils mittels eines Überbrückungsdosendeckels 30 verschlossen sind. Der Eingangsanschlußdosendeckel 26 und/oder der Ausgangsanschlußdosendeckel 28 und/oder die Überbrückungsdosendeckel 30 können an dem Solarmodul festgeklebt sein. Weiterhin weisen der Eingangsanschlußdosendeckel 26, der Ausgangsanschlußdosendeckel 28 und die Überbrückungsdosendeckel 30 jeweils eine Einfüllöffnung 32 auf, durch die in einem folgenden Schritt das Innere der Eingangsanschlußdose 6 bzw. der Ausgangsanschlußdose 8 bzw. der Überbrückungsdosen 22 mit Kunstharz ausgegossen wird. Folglich ist es möglich, daß der Eingangsanschlußdosendeckel 26, der Ausgangsanschlußdosendeckel 28 und die Überbrückungsdosendeckel 30 mittels eines Haftmittels, z.B. eines Klebebandes, an dem Solarmodul 2 fixiert werden und anschließend das jeweilige Innere mit dem Kunstharz ausgegossen wird. Durch das Kunstharz wird der Eingangsanschlußdosendeckel 26, der Ausgangsanschlußdosendeckel 28 und die Überbrückungsdosendeckel 30 an der entsprechenden Dose und/oder dem Solarmodul 2 fixiert. Es ist auch möglich, daß der Eingangsanschlußdosendeckel 26 und/oder der Ausgangsanschlußdosendeckel 28 und/oder die Überbrückungsdosendeckel 30 mit einem Werkzeug an der entsprechenden Dose angeordnet und dort gehalten werden, bis das Innere der Dose mit Kunstharz gefüllt ist und das Kunstharz soweit gehärtet ist, daß der Eingangsanschlußdosendeckel 26 und/oder der Ausgangsanschlußdosendeckel 28 und/oder die Überbrückungsdosendeckel 30 an der entsprechenden Dose und/oder dem Solarmodul 2 befestigt ist.

Ferner zeigt Figur 2, daß der Verbinder 20 der Ausgangsanschlußdose 8 durch einen komplementären Verbinder 34 mit der Eingangsanschlußdose eines weiteren Solarpaneels (nicht gezeigt) elektrisch verbunden ist. Mittels dieser elektrischen Verbindung können mehrere Solarpaneele 2 über z.B. eine Reihenschaltung verbunden werden. Alternativ zu der in Figur 2 gezeigten Konfiguration kann die Eingangsanschlußdose 6 anstelle des Kabels 14 auch einen Verbinder 2 aufweisen. Alternativ zu der in Figur 2 gezeigten Konfiguration kann die Ausgangsanschlußdose 8 anstelle des Verbinders 2 auch ein Kabel 14 aufweisen.

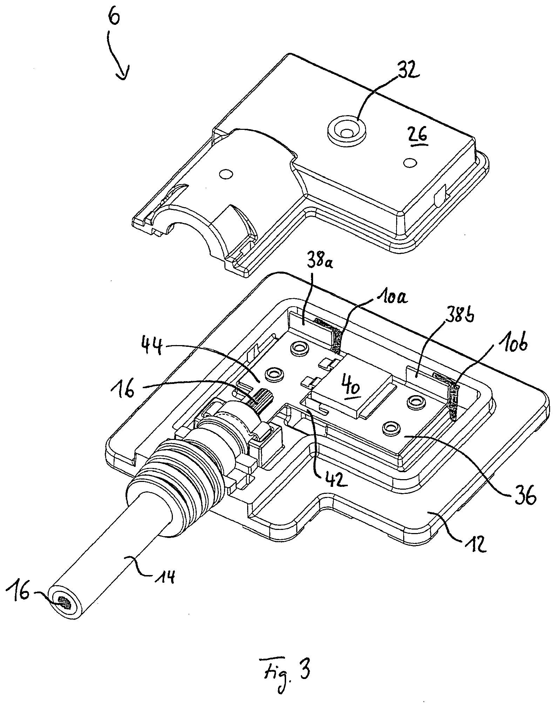

**Figur 3** zeigt eine perspektivische Explosionsansicht einer bevorzugten Ausführungsform der Eingangsanschlußdose 6. Die gezeigte elektrische Eingangsanschlußdose 6 umfaßt das Eingangsanschlußdosenanordnungselement 12 sowie eine Eingangsanschlußdosenkontakteinrichtung 36 mit zwei Leiterkontakten 38a, 38b und einer Diode 40. Zwei der elektrischen Leiter 10a, 10b des Solarmoduls 4 sind jeweils mit dem zugeordneten Leiterkontakt 38a, 38b der Eingangsanschlußdosenkontakteinrichtung 36 kontaktiert, insbesondere verlötet, d.h. der elektrische Leiter 10a ist mit dem Leiterkontakt 38a kontaktiert und der elektrische Leiter 10b ist mit dem Leiterkontakt 38b kontaktiert.

Die zwei Leiterkontakte 38a, 38b der Eingangsanschlußdosenkontakteinrichtung 36 sind zusammen einstückig ausgebildet, wobei die Eingangsanschlußdosenkontakteinrichtung 36 eine Sollbruchstelle 42 aufweist, um die zwei Leiterkontakte 38a, 38b vor oder während dem Schließen des Eingangsanschlußdosendeckels 26 zu dekontaktieren. Nach dem Trennen der Sollbruchstelle 42 und vor dem Ausgießen des Inneren der Eingangsanschlußdose 6 sind die zwei Leiterkontakte 38a, 38b lediglich mittels der Diode 40 mechanisch miteinander verbunden. Hierbei ist es möglich, daß die Leiterkontakte 38a, 38b an der Eingangsanschlußdose 6 fixiert sind. Beispielsweise können die Leiterkontakte 38a, 38b an der Eingangsanschlußdose 6 festgeklebt und/oder festgenietet und/oder festgeschweißt und/oder mittels einer mechanischen Verriegelungseinrichtung festgehalten werden.

Die Eingangsanschlußdose 6 in Figur 3 weist ein Kabel 14 mit einer Leitung 16 auf, die mit einem Leitungskontakt 44 der Eingangsanschlußdosenkontakteinrichtung 36 kontaktiert ist. Ferner weist das Kabel 14 eine Zugentlastung auf, die bereichsweise in einer entsprechend ausgebildeten Aufnahmeeinrichtung der Eingangsanschlußdose 6 angeordnet und dort fixiert ist. Insbesondere kann die Zugentlastung mit der Aufnahmeeinrichtung der Eingangsanschlußdose 6 verklebt sein, so daß das Innere der Eingangsanschlußdose 6 an der Aufnahmevorrichtung gegen die Umwelt feuchtigkeitsdicht abgeschlossen ist.

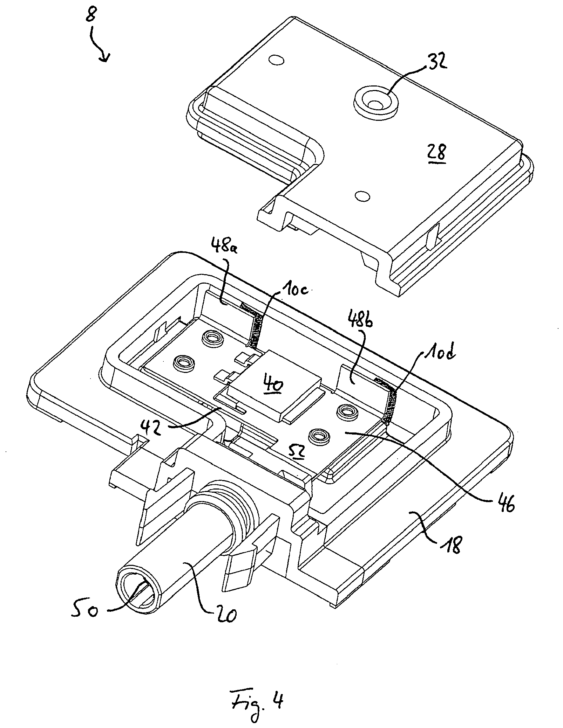

**Figur 4** zeigt eine perspektivische Explosionsansicht einer bevorzugten Ausführungsform der Ausgangsanschlußdose 8. Die gezeigte elektrische Ausgangsanschlußdose 8 umfaßt ein Ausgangsanschlußdosenanordnungselement 18 und eine Ausgangsanschlußdosenkontakteinrichtung 46 mit zwei Leiterkontakten 48a, 48b und einer Diode 40. Zwei der elektrische Leiter 10c, 10d des Solarmoduls 4 sind jeweils mit dem zugeordneten Leiterkontakt 48a, 48b der Ausgangsanschlußdosenkontakteinrichtung 46 kontaktiert, insbesondere verlötet, d.h. der elektrische Leiter 10c ist mit dem Leiterkontakt 48a kontaktiert und der elektrische Leiter 10d ist mit dem Leiterkontakt 48b kontaktiert.

Die zwei Leiterkontakte 48a, 48b der Ausgangsanschlußdosenkontakteinrichtung 46 sind zusammen einstückig ausgebildet, wobei die Ausgangsanschlußdosenkontakteinrichtung 46 eine Sollbruchstelle 42 aufweist, um die zwei Leiterkontakte 48a, 48b vor oder während dem Schließen des Ausgangsanschlußdosendeckels 28 zu dekontaktieren. Nach dem Trennen der Sollbruchstelle 42 und vor dem Ausgießen des Inneren der Ausgangsanschlußdose 8 sind die zwei Leiterkontakte 48a, 48b lediglich mittels der Diode 40 mechanisch miteinander verbunden.

Die Ausgangsanschlußdose 8 in Figur 4 weist einen Verbinder 20 mit einem Anschlußpol 50 auf, der mit einem Anschlußpolkontakt 52 der Ausgangsanschlußdosenkontakteinrichtung 46 kontaktiert ist. Vorzugsweise sind der Anschlußpolkontakt 52 der Ausgangsanschlußdosenkontakteinrichtung 46 und der Leitungskontakt 44 der Eingangsanschlußdosenkontakteinrichtung 36 im wesentlichen identisch ausgebildet.

Es versteht sich jedoch, daß die in der Figur 3 gezeigte Eingangsanschlußdose 6 ebenfalls als Ausgangsanschlußdose 8 dienen kann und umgekehrt, da die Funktion als Eingang bzw. Ausgang lediglich durch die Stromflußrichtung bestimmt wird. Die Eingangsanschlußdose 6 und die Ausgangsanschlußdose 8 können daher auch als Anschlußdosen bezeichnet werden, falls sie nicht in einem Solarpaneel 2 verbaut sind. Weiterhin gelten die zu Figur 3 gemachten Ausführungen in sinngemäßer Weise für Figur 4.

**Figur 5** zeigt eine perspektivische Explosionsansicht einer bevorzugten Ausführungsform der Überbrückungsdose 22. Die gezeigte elektrische Überbrückungsdose 22 umfaßt ein Überbrückungsdosenanordnungselement 24 mit einer Überbrückungsdosengrundplatte 24a und einem Haftmittel 24b. Weiterhin umfaßt die Überbrückungsdose 22 eine Überbrückungsdosenkontakteinrichtung 54 mit zwei Leiterkontakten 56a, 56b und einer Diode 40. Zwei der elektrischen Leiter 10e, 10f (Leiterbänder) des Solarmoduls 4 sind jeweils mit dem zugeordneten Leiterkontakt 56a, 56b der Überbrückungsdosenkontakteinrichtung 54 kontaktiert, insbesondere verlötet, d.h. der elektrische Leiter 10e ist mit dem Leiterkontakt 56a kontaktiert und der elektrische Leiter 10f ist mit dem Leiterkontakt 56b kontaktiert.

Die zwei Leiterkontakte 56a, 56b der Überbrückungsdosenkontakteinrichtung 54 sind zusammen einstückig ausgebildet, wobei die Überbrückungsdosenkontakteinrichtung 54 eine Sollbruchstelle 42 aufweist, um die zwei Leiterkontakte 56a, 56b vor oder während dem Schließen des Überbrückungsdosendeckels 30 zu dekontaktieren. Nach dem Trennen der Sollbruchstelle 42 und vor dem Ausgießen des Inneren der Überbrückungsdose 22 sind die zwei Leiterkontakte 56a, 56b lediglich mittels der SMD-Diode 40 mechanisch miteinander verbunden.

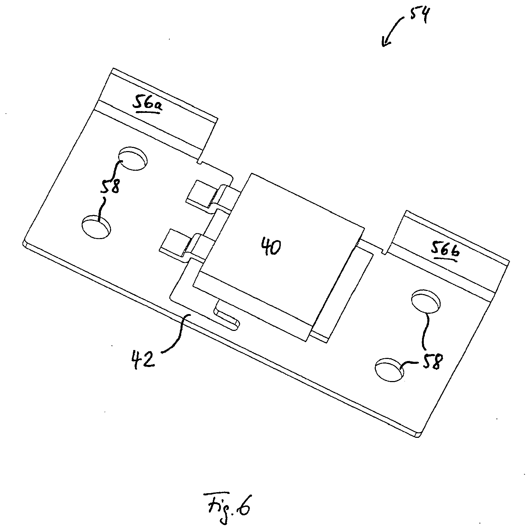

**Figur 6** zeigt eine perspektivische Ansicht einer bevorzugten Ausführungsform einer Überbrückungsdosenkontakteinrichtung 54 mit den zwei Leiterkontakten 56a, 56b, der SMD-Diode 40 und der Sollbruchstelle 42. Durch die Sollbruchstelle 42 sind die zwei Leiterkontakte 56a, 56b noch miteinander mechanisch und elektrisch verbunden. Zum betriebsmäßigen Gebrauch wird die Überbrückungsdosenkontakteinrichtung 54 an der Sollbruchstelle 42 in zwei Teile getrennt, so daß die elektrische Verbindung der beiden Teile lediglich über die Diode 40 und gegebenenfalls über eine an die Leiterkontakte 56a, 56b angeschlossene Solarzelle erfolgt.

Weiter weist die Überbrückungsdosenkontakteinrichtung 54 Befestigungsöffnungen 58 auf, mittels derer die Überbrückungsdosenkontakteinrichtung 54 an dem Solarmodul 4 befestigt werden kann. Insbesondere kann auf das Solarmodul 4 und/oder auf die Überbrückungsdosenkontakteinrichtung 54 ein Haftmittel, z.B. ein Klebemittel, ein Thermoplast, usw. aufgetragen werden, so daß das Haftmittel durch die Befestigungsöffnungen 58 dringt und die Überbrückungsdosenkontakteinrichtung 54 hintergreift, wenn die Überbrückungsdosenkontakteinrichtung 54 an dem Solarmodul zum Befestigen angeordnet ist. Alternativ oder zusätzlich könnte das Haftmittel auch auf die dem Solarmodul 4 zugewandten Seite der Überbrückungsdosenkontakteinrichtung 54 angeordnet sein ohne durch die Befestigungsöffnungen 58 zu dringen. Ebenso können die Befestigungsöffnungen 58 dazu dienen, Überbrückungsdosenkontakteinrichtung 54 an dem Solarmodul 4 und/oder an der Überbrückungsdosengrundplatte 24a durch Nieten, Schweißen, Kleben, usw. zu befestigen.

Ansonsten kann die Überbrückungsdosenkontakteinrichtung 54 im wesentlichen identisch zu der Anschlußdosenkontakteinrichtung bzw. Eingangsanschlußdosenkontakteinrichtung 36 bzw. der Ausgangsanschlußdosenkontakteinrichtung 46 ausgebildet sein.

Alternativ zu der in Figur 5 gezeigten Ausführungsform der Überbrückungsdose 22 kann in einer weiteren Ausführungsform die Überbrückungsdose 22 aus der Überbrückungsdosenkontakteinrichtung 54 und aus dem Überbrückungsdosendeckel 30 und gegebenenfalls einem Befestigungsmittel zum Befestigen der Überbrückungsdosenkontakteinrichtung 54 an dem Überbrückungsdosendeckel 30 (oder umgekehrt) und/oder an dem Solarmodul 4 bestehen. Folglich wird die Überbrückungsdose 22 erst dann zusammengesetzt, wenn die Überbrückungsdosenkontakteinrichtung 54 und der Überbrückungsdosendeckel 30 an dem Solarmodul 4 angeordnet sind. In dieser Ausführungsform kann die Überbrückungsdose 22 weiterhin ein oder mehrere Haftmittel, wie z.B. einen Kleber, ein Klebeband, usw. und/oder ein oder mehrere Befestigungsmittel, insbesondere Schrauben, Nieten, Schnappverschlüsse, Hinterschneidungen, Haken, Ösen, usw. zum Befestigen des Überbrückungsdosendeckels 30 an dem Solarmodul 4 und/oder zum Befestigen des Überbrückungsdosendeckels 30 an der Überbrückungsdosenkontakteinrichtung 54 und/oder zum Befestigen der Überbrückungsdosenkontakteinrichtung 54 an dem Solarmodul 4 umfassen.

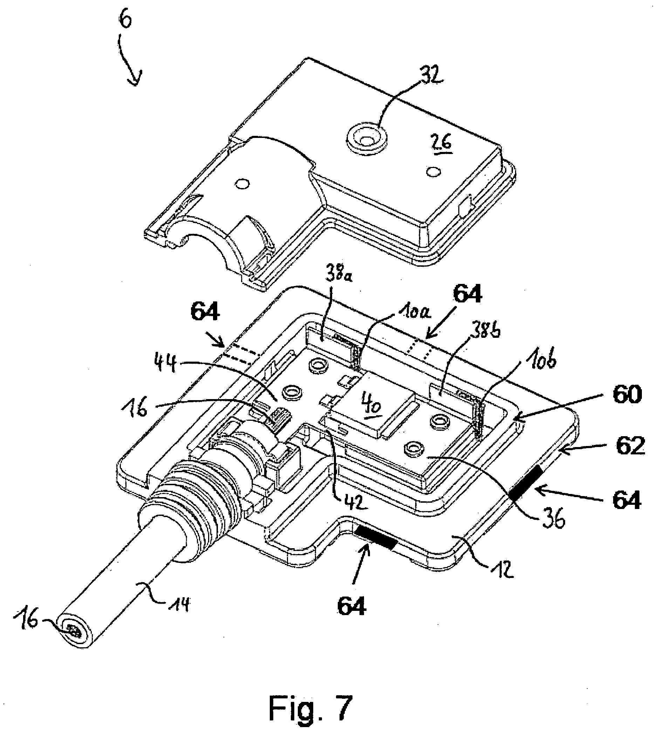

Die in **Figur 7** dargestellte Eingangsanschlußdose 6 ist eine Abwandlung der in Figur 3 dargestellten Eingangsanschlußdose 6, wobei gleiche Bezugszeichen in den beiden Figuren gleiche Teile bezeichnen. Wie in der zuvor genannten Figur weist die Eingangsanschlußdose eine Eingangsanschlußdosenbefestigungswand 60 und einen daran angeordneten Befestigungsflansch 62 auf. Die Eingangsanschlußdosenbefestigungswand 60 ist mit dem Befestigungsflansch 62 einstückig ausgebildet. In dem hier gezeigten Befestigungsflansch 62 sind vier Kanäle 64 (teilweise schematisch mittels Strichlinie gezeigt) ausgebildet, durch die bei einem Vergießen der Eingangsanschlußdose überschüssige Vergußmasse bzw. Ausgießmasse austreten kann. Diese kann bei Bedarf entfernt werden. Alternativ kann vorgesehen sein, die Kanäle über die Breite des Befestigungsflansches nicht durchgängig auszugestalten.

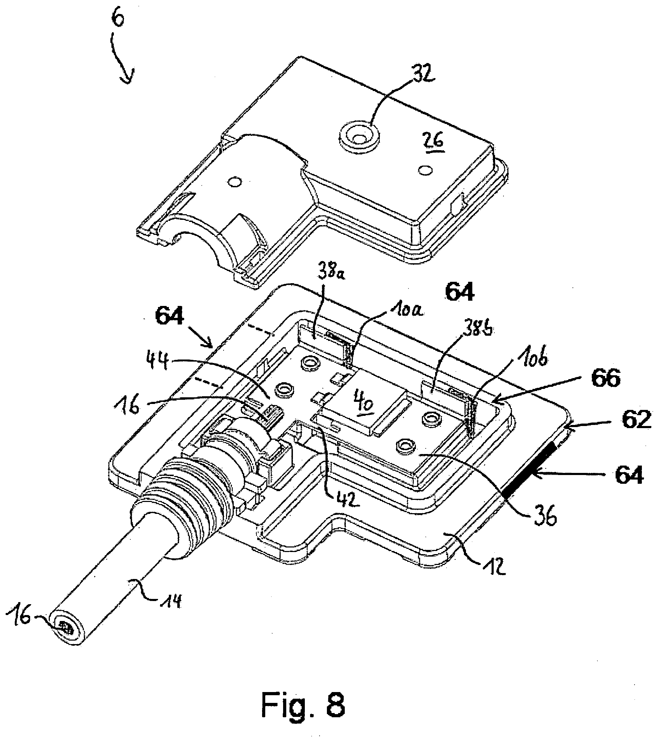

Die in **Figur 8** dargestellte Ausgangsanschlußdose 8 ist eine Abwandlung der in Figur 4 dargestellten Ausgangsanschlußdose 8, wobei gleiche Bezugszeichen in den beiden Figuren gleiche Teile bezeichnen. Wie in der zuvor genannten Figur weist die Ausgangsanschlußdose eine Ausgangsanschlußdosenbefestigungswand 66 und einen daran angeordneten Befestigungsflansch 62 auf. Die Ausgangsanschlußdosenbefestigungswand 60 ist mit dem Befestigungsflansch 62 einstückig ausgebildet. In dem hier gezeigten Befestigungsflansch 62 sind zwei Kanäle 64 (teilweise schematisch mittels Strichlinie gezeigt) ausgebildet, die anders als in Figur 6 breiter ausgestaltet sind.

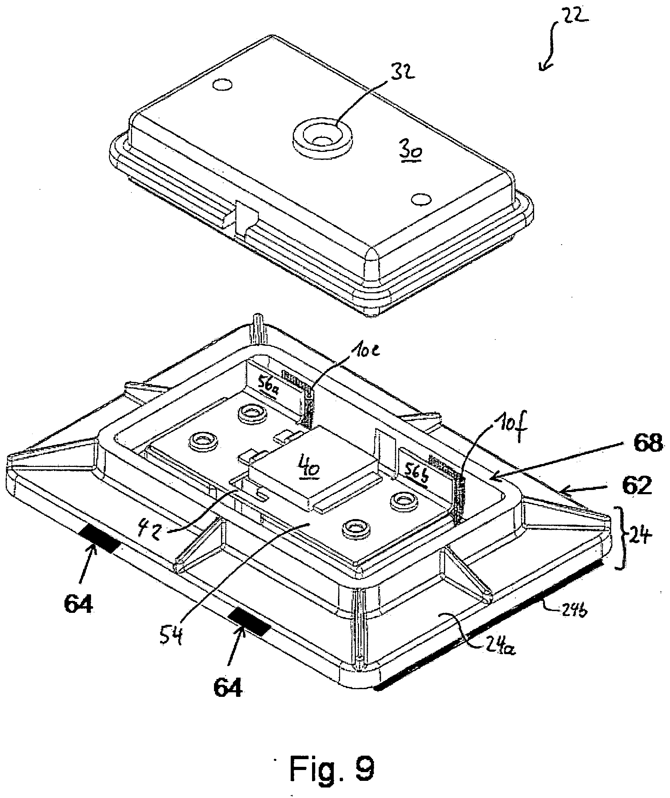

Die in **Figur 9** schließlich dargestellte Überbrückungsdose 22 ist eine Abwandlung der in Figur 5 dargestellten Überbrückungsdose 8, wobei gleiche Bezugszeichen in den beiden Figuren gleiche Teile bezeichnen. Wie in der zuvor genannten Figur weist die Überbrückungsdose eine Überbrückungsdosenbefestigungswand 68 und einen daran angeordneten Befestigungsflansch 62 auf. Die Überbrückungsdosenbefestigungswand 68 ist mit dem Befestigungsflansch 62 einstückig ausgebildet. In dem hier gezeigten Befestigungsflansch 62 sind zwei Kanäle 64 ausgebildet, die sich zur gleichen Seite des Befestigungsflansches 62 hin öffnen.

Es sei an dieser Stelle angemerkt, daß weder an der Eingangsanschlußdosenbefestigungswand 60, noch an der Ausgangsanschlußdosenbefestigungswand 66 oder der Überbrückungsdosenbefestigungswand 68 ein Befestigungsflansch 62 zwingend vorgesehen sein muß. Auch können die Eingangsanschlußdosenbefestigungswand 60, die Ausgangsanschlußdosenbefestigungswand 66 und die Überbrückungsdosenbefestigungswand 68 nur an diskreten Stellen mit einem Befestigungsflansch 62 versehen sein.

Die in den Figuren 7 bis 9 dargestellten Eingangsanschlußdose 6, Ausgangsanschlußdose 8 und Überbrückungsdose 22 können fakultativ jeweils einen Boden (nicht gezeigt) aufweisen. Dieser kann Durchbrüche (nicht gezeigt) aufweisen, damit die Füllmasse, die während der Herstellung in Eingangsanschlußdose 6, die Ausgangsanschlußdose 8 und Überbrückungsdose 22 hineingegossen wird, eine innige Verbindung zwischen den zuvor genannten Bauteilen und dem Solarpaneel 2 erzeugt wird.

Die nicht näher gezeigte Füllmasse kann ein Kunstharz, ein Polymer oder ein Elastomer, insbesondere ein Silikon, sein. Dies ist jedoch nicht zwingend, solange die Füllmasse insbesondere elektrisch isolierend, umweltbeständig und eine innige Verbindung schaffend ausgebildet ist.

### Bezugszeichenliste

- 2: Solarpaneel
- 4: Solarmodul
- 6: Eingangsanschlußdose
- 8: Ausgangsanschlußdose
- 10a - 10j: elektrische Leiter
- 12: Eingangsanschlußdosenanordnungselement
- 12a: Eingangsanschlußdosengrundplatte
- 14: Kabel
- 16: Leitung bzw. Leitungsader
- 18: Ausgangsanschlußdosenanordnungselement
- 18a: Ausgangsanschlußdosengrundplatte
- 20: Verbinder
- 22: Überbrückungsdose
- 24: Überbrückungsdosenanordnungselement
- 24a: Überbrückungsdosengrundplatte
- 24b: Haftmittel
- 26: Eingangsanschlußdosendeckel
- 28: Ausgangsanschlußdosendeckel
- 30: Überbrückungsdosendeckel
- 32: Einfüllöffnung
- 34: komplementärer Verbinder
- 36: Eingangsanschlußdosenkontakteinrichtung
- 38a, 38b: Leiterkontakt
- 40: Diode
- 42: Sollbruchstelle
- 44: Leitungskontakt bzw. Leitungsaderkontakt
- 46: Ausgangsanschlußdosenkontakteinrichtung
- 48a, 48b: Leiterkontakt
- 50: Anschlußpol
- 52: Anschlußpolkontakt
- 54: Überbrückungsdosenkontakteinrichtung
- 56a, 56b: Leiterkontakt
- 58: Befestigungsöffnung
- 60: Eingangsanschlußdosenbefestigungswand
- 62: Befestigungsflansch
- 64: Kanal
- 66: Ausgangsanschlußdosenbefestigungswand
- 68: Überbrückungsdosenbefestigungswand

## Patentansprüche

1. Solarpaneel, umfassend:
- ein Solarmodul (4) mit
-- zumindest vier elektrischen Leitern (10a-10d), die auf einer der lichtaktiven Fläche des Solarmoduls (4) gegenüberliegenden Anschlußfläche in Form dünner Leiterbänder aus dem Solarmodul (4) herausgeführt werden,
- eine elektrische Eingangsanschlußdose (6), mit
-- einem Eingangsanschlußdosenanordnungselement (12) und
-- einer Eingangsanschlußdosenkontakteinrichtung (36) mit zwei Leiterkontakten (38a, 38b) und zumindest einer Diode (40),
wobei zwei der elektrischen Leiter (10a, 10b) des Solarmoduls (4) jeweils mit einem zugeordneten Leiterkontakt (38a, 38b) der Eingangsanschlußdosenkontakteinrichtung (36) kontaktiert sind, und wobei die zwei Leiterkontakte (38a, 38b) mittels der Diode (40) elektrisch verbunden sind,
- eine elektrische Ausgangsanschlußdose (8), mit
-- einem Ausgangsanschlußdosenanordnungselement (18) und
-- einer Ausgangsanschlußdosenkontakteinrichtung (46) mit zwei Leiterkontakten (48a, 48b) und zumindest einer Diode (40),
wobei zwei der elektrischen Leiter (10c, 10d) des Solarmoduls (4) jeweils mit einem zugeordneten Leiterkontakt (48a,48b) der Ausgangsanschlußdosenkontakteinrichtung (46) kontaktiert sind, und wobei die zwei Leiterkontakte (48a, 48b) mittels der Diode (40) elektrisch verbunden sind, wobei die Eingangsanschlußdose (6) mittels des Eingangsanschlußdosenanordnungselements (12) und die Ausgangsanschlußdose (8) mittels des Ausgangsanschlußdosenanordnungselements (18) vom Rand des Solarmoduls (4) beabstandet und voneinander beabstandet an dem Solarmodul (4) angeordnet sind.

2. Solarpaneel nach Anspruch 1, wobei die Eingangsanschlußdose (6) genau einen elektrischen Verbinder mit einem Anschlußpol aufweist, der mit einem Anschlußpolkontakt der Eingangsanschlußdosenkontakteinrichtung (36) kontaktiert ist, oder die Eingangsanschlußdose (6) genau ein Kabel (14) mit genau einer Leitung (16) aufweist, die mit einem Leitungskontakt (44) der Eingangsanschlußdosenkontakteinrichtung (36) kontaktiert ist,
und/oder
die Ausgangsanschlußdose (8) genau einen elektrischen Verbinder (20) mit einem Anschlußpol (50) aufweist, der mit einem Anschlußpolkontakt (52) der Ausgangsanschlußdosenkontakteinrichtung (46) kontaktiert ist, oder die Ausgangsanschlußdose (8) genau ein Kabel mit genau einer Leitung aufweist, die mit einem Leitungskontakt der Ausgangsanschlußdosenkontakteinrichtung (46) kontaktiert ist.

3. Solarpaneel nach einem der vorherigen Ansprüche, weiter umfassend:
- zumindest eine elektrische Überbrückungsdose (22), mit
-- einem Überbrückungsdosenanordnungselement (24) und
-- einer Überbrückungsdosenkontakteinrichtung (54) mit zwei Leiterkontakten (56a, 56b) und zumindest einer Diode (40),
wobei zwei der elektrischen Leiter (10e, 10f) des Solarmoduls (4) jeweils mit einem zugeordneten Leiterkontakt (56a, 56b) der Überbrückungsdosenkontakteinrichtung (54) kontaktiert sind, wobei die zwei Leiterkontakte (56a, 56b) mittels der Diode (40) elektrisch verbunden sind und
wobei die zumindest eine Überbrückungsdose (22) mittels des Überbrückungsdosenanordnungselements (24) von der Eingangsanschlußdose (6) und der Ausgangsanschlußdose (8) beabstandet an dem Solarmodul (4) befestigt ist.

4. Solarpaneel nach einem der vorherigen Ansprüche, wobei das Eingangsanschlußdosenbefestigungselement (12) eine Eingangsanschlußdosenbefestigungswand (60), von der ein Befestigungsflansch (62) abragt,
und/oder
das Ausgangsanschlußdosenanordnungselement (18) eine Ausgangsanschlußdosenbefestigungswand (66), von der ein Befestigungsflansch (62) abragt,
und/oder
das Überbrückungsdosenanordnungselement (24) eine Überbrückungsdosenbefestigungswand (68), von der ein Befestigungsflansch (62) abragt, aufweist

5. Solarpaneel nach einem der vorherigen Ansprüche, wobei die Eingangsanschlußdose (6) einen Eingangsanschlußdosendeckel (26) und/oder die Ausgangsanschlußdose (8) einen Ausgangsanschlußdosendeckel (28) und/oder die zumindest eine Überbrückungsdose (22) einen Überbrückungsdosendeckel (30) aufweist und wobei der Eingangsanschlußdosendeckel (26) und/oder der Ausgangsanschlußdosendeckel (28) und/oder der zumindest eine Überbrückungsdosendeckel (30) eine Einfüllöffnung (32) aufweist.

6. Solarpaneel nach einem der vorherigen Ansprüche, wobei das Innere der Eingangsanschlußdose (6) und/oder der Ausgangsanschlußdose (8) und/oder der zumindest einen Überbrückungsdose (22) feuchtigkeitsdichtend mit einer Ausgießmasse ausgegossen ist, um die Eingangsanschlußdose (6) und/oder die Ausgangsanschlußdose (8) und/oder die zumindest eine Überbrückungsdose (22) an dem Solarmodul (4) zu befestigen.

7. Solarpaneel nach einem der vorherigen Ansprüche, wobei die Eingangsanschlußdosenkontakteinrichtung (36) und/oder die Ausgangsanschlußdosenkontakteinrichtung (46) und/oder die zumindest eine Überbrückungsdosenkontakteinrichtung (54) zwei Leiterkontakte aufweist, welche mittels der Diode (40) mechanisch miteinander verbunden sind.

8. Solarpaneel nach einem der vorherigen Ansprüche, wobei der Anschlußpolkontakt oder der Leitungskontakt (44) der Eingangsanschlußdosenkontakteinrichtung (36) mit einem der Leiterkontakte (38a, 38b) einstückig ausgebildet ist und/oder der Anschlußpolkontakt (52) oder der Leitungskontakt der Ausgangsanschlußdosenkontakteinrichtung (46) mit einem der Leiterkontakte (48a, 48b) einstückig ausgebildet ist.

9. Verfahren zum Herstellen eines Solarpaneels (2), umfassend die Schritte:
- Bereitstellen eines Solarmoduls (4) mit
-- zumindest vier elektrischen Leitern (10a-10d), die auf einer der lichtaktiven Fläche des Solarmoduls (4) gegenüberliegenden Anschlußfläche in Form dünner Leiterbänder aus dem Solarmodul (4) herausgeführt werden,
- Bereitstellen einer elektrischen Eingangsanschlußdose (6) mit
-- einem Eingangsanschlußdosenanordnungselement (12) und
-- einer Eingangsanschlußdosenkontakteinrichtung (36) mit zwei Leiterkontakten (38a, 38b) und zumindest einer Diode (40), welche die zwei Leiterkontakte (38a, 38b) elektrisch verbindet,
- Anordnen der Eingangsanschlußdose (6) an dem Solarmodul (4), wobei zwei der elektrischen Leiter (10a, 10b) des Solarmoduls (4) jeweils mit einem zugeordneten Leiterkontakt (38a, 38b) der Eingangsanschlußdosenkontakteinrichtung (36) kontaktiert werden,
- Bereitstellen einer elektrischen Ausgangsanschlußdose (8), mit
-- einem Ausgangsanschlußdosenanordnungselement (18) und
-- einer Ausgangsanschlußdosenkontakteinrichtung (46) mit zwei Leiterkontakten (48a, 48b) und zumindest einer Diode (40), welche die zwei Leiterkontakte (48a, 48b) elektrisch verbindet,
- Anordnen der Ausgangsanschlußdose (8) an dem Solarmodul (4), wobei zwei der elektrischen Leiter (10c, 10d) des Solarmoduls (4) jeweils mit einem zugeordneten Leiterkontakt (48a, 48b) der Ausgangsanschlußdosenkontakteinrichtung (46) kontaktiert werden, wobei die Eingangsanschlußdose (6) mittels des Eingangsanschlußdosenanordnungselements (12) und die Ausgangsanschlußdose (8) mittels des Ausgangsanschlußdosenanordnungselements (18) vom Rand des Solarmoduls (4) beabstandet und voneinander beabstandet an dem Solarmodul (4) angeordnet werden.

10. Verfahren nach Anspruch 9, weiter umfassend die Schritte:
- Bereitstellen zumindest einer elektrischen Überbrückungsdose (22), mit
-- einem Überbrückungsdosenanordnungselement (24) und
-- einer Überbrückungsdosenkontakteinrichtung (54) mit zwei Leiterkontakten (56a, 56b) und zumindest einer Diode (40), welche die zwei Leiterkontakten (56a, 56b) elektrisch verbindet,
- Anordnen der Überbrückungsdose (22) mittels des Überbrückungsdosenanordnungselements (24) an dem Solarmodul (4), wobei zwei der elektrischen Leiter (10e, 10f) des Solarmoduls (4) jeweils mit einem zugeordneten Leiterkontakt (56a, 56b) der Überbrückungsdosenkontakteinrichtung (54) kontaktiert werden und
wobei die zumindest eine Überbrückungsdose (22) von der Eingangsanschlußdose (6) und der Ausgangsanschlußdose (8) beabstandet an dem Solarmodul (4) angeordnet wird.

11. Verfahren nach Anspruch 10, wobei das Überbrückungsdosenanordnungselement (24) ein an der Überbrückungsdosenkontakteinrichtung (54) angeordnetes Haftmittel ist und wobei die Überbrückungsdosenkontakteinrichtung (54) mittels des Haftmittels an dem Solarmodul (4) befestigt wird.

12. Verfahren nach Anspruch 9 bis 11, umfassend den weiteren Schritt:
- Trennen der Eingangsanschlußdosenkontakteinrichtung (36) und/oder der Ausgangsanschlußdosenkontakteinrichtung (46) und/oder der zumindest einen Überbrückungsdosenkontakteinrichtung (54) an einer Sollbruchstelle (42).

13. Verfahren nach Anspruch 9 bis 12, umfassend den weiteren Schritt:
- Ausgießen des Inneren der Eingangsanschlußdose (6) und/oder der Ausgangsanschlußdose (8) und/oder der zumindest einen Überbrückungsdose (22) mit einem Kunstharz oder einem Polymer oder einem Elastomer, um die Eingangsanschlußdose (6) und/oder die Ausgangsanschlußdose (8) und/oder die zumindest eine Überbrückungsdose (22) an dem Solarmodul (4) zu befestigen.

14. Überbrückungsdose (22), umfassend:
- ein Überbrückungsdosenanordnungselement (24),
- eine Überbrückungsdosenkontakteinrichtung (54) mit
-- zwei Leiterkontakten (56a, 56b),
-- zumindest einer Diode (40), welche die zwei Leiterkontakte (56a, 56b) elektrisch verbindet, und
einem direkt an der Überbrückungsdosenkontakteinrichtung (54) angeordnetem Haftmittel, mit welchem die Überbrückungsdosenkontakteinrichtung (54) an dem Solarmodul (4) befestigbar ist.

15. Überbrückungsdose (22) nach Anspruch 14, wobei das Haftmittel einen Haftkleber, einen Schmelzkleber und/oder ein doppelseitiges Klebeband umfaßt.

## Claims

1. A solar panel, comprising:
- a solar module (4) with
-- at least four electrical conductors (10a-10d), which are lead out of the solar module (4) on a contact surface lying opposite the light-active surface of the solar module (4) in the form of thin conductive strips,
- an electrical inlet socket (6) with
-- an inlet socket arrangement element (12) and
-- an inlet socket contact apparatus (36) with two conductor contacts (38a, 38b) and at least one diode (40),
wherein two of the electrical conductors (10a, 10b) of the solar module (4) are contacted respectively with an associated conductor contact (38a, 38b) of the inlet socket contact apparatus (36) and wherein the two conductor contacts (38a, 38b) are electrically connected by means of the diode (40),
- an electrical outlet socket (8), with
-- an outlet socket arrangement element (18) and
-- an outlet socket contact apparatus (46) with two conductor contacts (48a, 48b) and at least one diode (40),
wherein two of the electrical conductors (10c, 10d) of the solar module (4) are respectively contacted with an associated conductor contact (48a, 48b) of the outlet socket contact apparatus (46) and wherein the two conductor contacts (48a, 48b) are electrically connected by means of the diode (40),
wherein the inlet socket (6) is spaced from the edge of the solar module (4) by means of the inlet socket arrangement element (12) and the outlet socket (8) by means of the outlet socket arrangement element (18) and are arranged spaced from each other on the solar module (4).

2. The solar panel according to claim 1, wherein the inlet socket (6) has exactly one electrical connector with a terminal, which is contacted with a terminal contact of the inlet socket contact apparatus (36) or the inlet socket (6) has exactly one cable (14) with exactly one line (16), which is contacted with a line contact (44) of the inlet socket contact apparatus (36),
and/or
the outlet socket (8) has exactly one electrical connector (20) with a terminal (50), which is contacted with a terminal contact (52) of the outlet socket contact apparatus (46), or the outlet socket (8) has exactly one cable with exactly one line, which is contacted with a line contact of the outlet socket contact apparatus (46).

3. The solar panel according to one of the preceding claims, further comprising:
- at least one electrical bypass plug (22) with
-- a bypass plug arrangement element (24) and
-- a bypass plug contact apparatus (54) with two conductor contacts (56a, 56b) and at least one diode (40),
wherein two of the electrical conductors (10e, 10f) of the solar module (4) are respectively contacted with an associated conductor contact (56a, 56b) of the bypass plug contact apparatus (54),
wherein the two conductor contacts (56a, 56b) are electrically connected by means of the diode (40) and
wherein the at least one bypass plug (22) is fastened on the solar module (4) spaced from the inlet socket (6) and the outlet socket (8) by means of the bypass plug arrangement element (24).

4. The solar panel according to one of the preceding claims, wherein the inlet socket fastening element (12) has an inlet socket fastening wall (60), from which a fastening flange protrudes (62),
and/or
the outlet socket arrangement element (18) has an outlet socket fastening wall (66), from which a fastening flange (62) protrudes,
and/or
the bypass plug arrangement element (24) has a bypass plug fastening wall (68), from which a fastening flange (62) protrudes.

5. The solar panel according to one of the preceding claims, wherein the inlet socket (6) has an inlet socket cover (26) and/or the outlet socket (8) has an outlet socket cover (28) and/or the at least one bypass plug (22) has a bypass plug cover (30) and wherein the inlet socket cover (26) and/or the outlet socket cover (28) and/or the at least one bypass plug (30) has a fill opening (32).

6. The solar panel according to one of the preceding claims, wherein the interior of the inlet socket (6) and/or of the outlet socket (8) and/or of the at least one bypass plug (22) is poured in a moisture-proof manner with a pouring material in order to fasten the inlet socket (6) and/or the outlet socket (8) and/or the at least one bypass plug (22) on the solar module (4).

7. The solar panel according to one of the preceding claims, wherein the inlet socket contact apparatus (36) and/or the outlet socket contact apparatus (46) and/or the at least one bypass plug contact apparatus (54) has two conductor contacts which are mechanically interconnected by means of the diode (40).

8. The solar panel according to one of the preceding claims, wherein the terminal contact or the line contact (44) of the inlet socket contact apparatus (36) is designed as one piece with one of the conductor contacts (38a, 38b) and/or the terminal contact (52) or the line contact of the outlet socket contact apparatus (46) is designed as one piece with one of the conductor contacts (48a, 48b).

9. A method for producing a solar panel (2), comprising the steps:
- provision of a solar module (4) with
-- at least four electrical conductors (10a-10d), which are lead out of the solar module (4) on a contact surface lying opposite the light-active surface of the solar module (4) in the form of thin conductive strips,
- provision of an electrical inlet socket (6) with
-- an inlet socket arrangement element (12) and
-- an inlet socket contact apparatus (36) with two conductor contacts (38a, 38b) and at least one diode (40), which electrically connects the two conductor contacts (38a, 38b),
- arrangement of the inlet socket (6) on the solar module (4), wherein two of the electrical conductors (10a, 10b) of the solar module (4) are contacted respectively with an associated conductor contact (38a, 38b) of the inlet socket contact apparatus (36),
- provision of an electrical outlet socket (8), with
-- an outlet socket arrangement element (18) and
-- an outlet socket contact apparatus (46) with two conductor contacts (48a, 48b) and at least one diode (40), which electrically connects the two conductor contacts (48a, 48b),
- arrangement of the outlet socket (8) on the solar module (4), wherein two of the electrical conductors (10c, 10d) of the solar module (4) are contacted respectively with an associated conductor contact (48a, 48b) of the outlet socket contact apparatus (46),
wherein the inlet socket (6) is spaced from the edge of the solar module (4) by means of the inlet socket arrangement element (12) and the outlet socket (8) by means of the outlet socket arrangement element (18) and are arranged spaced from each other on the solar module (4).

10. The method according to claim 9, further comprising the steps:
- provision of at least one electrical bypass plug (22) with
-- a bypass plug arrangement element (24) and
-- a bypass plug contact apparatus (54) with two conductor contacts (56a, 56b) and at least one diode (40), which electrically connects the two conductor contacts (56a, 56b),
- arrangement of the bypass plug (22) on the solar module (4) by means of the bypass plug arrangement element (24), wherein two of the electrical conductors (10e, 10f) of the solar module (4) are contacted respectively with an associated conductor contact (56a, 56b) of the bypass plug contact apparatus (54) and
wherein the at least one bypass plug (22) is arranged on the solar module (4) spaced from the inlet socket (6) and the outlet socket (8).

11. The method according to claim 10, wherein the bypass plug arrangement element (24) is an adhesive arranged on the bypass plug contact apparatus (54) and wherein the bypass plug contact apparatus (54) is fastened on the solar module (4) by means of the adhesive.

12. The method according to claims 9 to 11, comprising the further step:
- separation of the inlet socket contact apparatus (36) and/or the outlet socket contact apparatus (46) and/or the at least one bypass plug contact apparatus (54) at a predetermined breaking point (42).

13. The method according to claims 9 to 12, comprising the further step:
- pouring of the interior of the inlet socket (6) and/or the outlet socket (8) and/or the at least one bypass plug (22) with a synthetic resin or a polymer or an elastomer in order to fasten the inlet socket (6) and/or the outlet socket (8) and/or the at least one bypass plug (22) on the solar module (4).

14. A bypass plug (22), comprising:
- a bypass plug arrangement element (24),
- a bypass plug contact apparatus (54) with
-- two conductor contacts (56a, 56b),
-- at least one diode (40), which electrically connects the two conductor contacts (56a, 56b) and
an adhesive arranged directly on the bypass plug contact apparatus (54), with which the bypass plug contact apparatus (54) can be fastened on the solar module (4).

15. The bypass plug (22) according to claim 14, wherein the adhesive comprises a contact adhesive, a hotmelt adhesive and/or a double-sided adhesive tape.

## Revendications

1. Panneau solaire, comportant :
- un module solaire (4) avec
• au moins quatre conducteurs électriques (10a - 10d) qui sont amenés hors du module solaire (4), sur une surface de raccordement étant opposée à la surface photosensible du module solaire (4), sous forme de rubans conducteurs,
- une boîte de jonction d'entrée électrique (6), avec
• un élément d'agencement de boîte de jonction d'entrée (12) et
• un dispositif de contact de boîte de jonction d'entrée (36) pourvu de deux contacts conducteurs (38a, 38b) et d'au moins une diode (40),
où deux des conducteurs électriques (10a, 10b) du module solaire (4) sont mis en contact respectivement avec un contact conducteur associé (38a, 38b) du dispositif de contact de boîte de jonction d'entrée (36), et où les deux contacts conducteurs (38a, 38b) sont reliés électriquement à l'aide de la diode (40),
- une boîte de jonction de sortie électrique (8), avec
• un élément d'agencement de boîte de jonction de sortie (18) et
• un dispositif de contact de boîte de jonction de sortie (46) pourvu de deux contacts conducteurs (48a, 48b) et d'au moins une diode (40),
où deux des conducteurs électriques (10c, 10d) du module solaire (4) sont mis en contact respectivement avec un contact conducteur associé (48a, 48b) du dispositif de contact de boîte de jonction de sortie (46), et où les deux contacts conducteurs (48a, 48b) sont reliés électriquement à l'aide de la diode (40),
où la boîte de jonction d'entrée (6) est agencée, à l'aide de l'élément d'agencement de boîte de jonction d'entrée (12), et la boîte de jonction de sortie (8) est agencée, à l'aide de l'élément d'agencement de boîte de jonction de sortie (18), sur le module solaire (4), les deux boîtes (6) et (8) étant mutuellement espacées et également espacées du bord du module solaire (4).

2. Module solaire selon la revendication 1, où la boîte de jonction d'entrée (6) présente exactement un connecteur électrique pourvu d'un pôle de raccordement qui est mis en contact avec un contact de pôle de raccordement du dispositif de contact de boîte de jonction d'entrée (36), ou la boîte de jonction d'entrée (6) présente exactement un câble (14) avec exactement une ligne (16) qui est mise en contact avec un contact conducteur (44) du dispositif de contact de boîte de jonction d'entrée (36),
et/ou
la boîte de jonction de sortie (8) présente exactement un connecteur électrique (20) pourvu d'un pôle de raccordement (50) qui est mis en contact avec un contact de pôle de raccordement (52) du dispositif de contact de boîte de jonction de sortie (46), ou la boîte de jonction de sortie (8) présente exactement un câble avec exactement une ligne qui est mise en contact avec un contact conducteur du dispositif de contact de boîte de jonction de sortie (46).

3. Module solaire selon l'une quelconque des revendications précédentes, comportant en outre :
- au moins une boîte de pontage électrique (22), avec
• un élément d'agencement de boîte de pontage (24) et
• un dispositif de contact de boîte de pontage (54) pourvu de deux contacts conducteurs (56a, 56b) et d'au moins une diode (40),
où deux des conducteurs électriques (10e, 10f) du module solaire (4) sont mis en contact respectivement avec un contact conducteur associé (56a, 56b) du dispositif de contact de boîte de pontage (54),
où les deux contacts conducteurs (56a, 56b) sont reliés électriquement à l'aide de la diode (40) et
où ladite au moins une boîte de pontage (22) est fixée sur le module solaire (4) à l'aide de l'élément d'agencement de boîte de pontage (24), espacée de la boîte de jonction d'entrée (6) et de la boîte de jonction de sortie (8).

4. Panneau solaire selon l'une quelconque des revendications précédentes, où l'élément de fixation de boîte de jonction d'entrée (12) présente une paroi de fixation de boîte de jonction d'entrée (60) à partir de laquelle une bride de fixation (62) fait saillie,
et/ou
l'élément d'agencement de boîte de jonction de sortie (18) présente une paroi de fixation de boîte de jonction de sortie (66) à partir de laquelle une bride de fixation (62) fait saillie,
et/ou
l'élément d'agencement de boîte de pontage (24) présente une paroi de fixation de boîte de pontage (68) à partir de laquelle une bride de fixation (62) fait saillie.

5. Panneau solaire selon l'une quelconque des revendications précédentes, où la boîte de jonction d'entrée (6) présente un couvercle de boîte de jonction d'entrée (26) et/ou la boîte de jonction de sortie (8) présente un couvercle de boîte de jonction de sortie (28) et/ou ladite au moins une boîte de pontage (22) présente un couvercle de boîte de pontage (30) et où le couvercle de boîte de jonction d'entrée (26) et/ou le couvercle de boîte de jonction de sortie (28) et/ou ledit au moins un couvercle de boîte de pontage (30) présente une ouverture d'introduction (32).

6. Panneau solaire selon l'une quelconque des revendications précédentes, où l'intérieur de la boîte de jonction d'entrée (6) et/ou de la boîte de jonction de sortie (8) et/ou ladite au moins une boîte de pontage (22) est remplie avec une masse de coulée de manière étanche à l'humidité de sorte à fixer la boîte de jonction d'entrée (6) et/ou la boîte de jonction de sortie (8) et/ou ladite au moins une boîte de pontage (22) sur le module solaire (4).

7. Panneau solaire selon l'une quelconque des revendications précédentes, où le dispositif de contact de boîte de jonction d'entrée (36) et/ou le dispositif de contact de boîte de jonction de sortie (46) et/ou ledit au moins un dispositif de contact de boîte de pontage (54) présente deux contacts conducteurs qui sont reliés mécaniquement l'un à l'autre à l'aide de la diode (40).

8. Panneau solaire selon l'une quelconque des revendications précédentes, où le contact de pôle de raccordement ou le contact de ligne (44) du dispositif de contact de boîte de jonction d'entrée (36) est conçu d'une seule pièce avec un des contacts conducteurs (38a, 38b) et/ou le contact de pôle de raccordement (52) ou le contact de ligne du dispositif de contact de boîte de jonction de sortie (46) est conçu d'une seule pièce avec un des contacts conducteurs (48a, 48b).

9. Procédé de production d'un module solaire (2), comportant les étapes suivantes :
- la mise à disposition d'un module solaire (4) avec
• au moins quatre conducteurs électriques (10a - 10d) qui sont amenés hors du module solaire (4), sur une surface de raccordement étant opposée à la surface photosensible du module solaire (4), sous forme de rubans conducteurs,
- la mise à disposition d'une boîte de jonction d'entrée électrique (6) avec
• un élément d'agencement de boîte de jonction d'entrée (12) et
• un dispositif de contact de boîte de jonction d'entrée (36) pourvu de deux contacts conducteurs (38a, 38b) et d'au moins une diode (40) qui relie électriquement les deux contacts conducteurs (38a, 38b),
- l'agencement de la boîte de jonction d'entrée (6) sur le module solaire (4), où deux des conducteurs électriques (10a, 10b) du module solaire (4) sont mis en contact respectivement avec un contact conducteur associé (38a, 38b) du dispositif de contact de boîte de jonction d'entrée (36),
- la mise à disposition d'une boîte de jonction de sortie électrique (8), avec
• un élément d'agencement de boîte de jonction de sortie (18) et
• un dispositif de contact de boîte de jonction de sortie (46) pourvu de deux contacts conducteurs (48a, 48b) et d'au moins une diode (40) qui relie électriquement les deux contacts conducteurs (48a, 48b),
- l'agencement de la boîte de jonction de sortie (8) sur le module solaire (4), où deux des conducteurs électriques (10c, 10d) du module solaire (4) sont mis en contact respectivement avec un contact conducteur associé (48a, 48b) du dispositif de contact de boîte de jonction de sortie (46),
où la boîte de jonction d'entrée (6) est agencée, à l'aide de l'élément d'agencement de boîte de jonction d'entrée (12), et la boîte de jonction de sortie (8) est agencée, à l'aide de l'élément d'agencement de boîte de jonction de sortie (18), sur le module solaire (4), les deux boîtes (6) et (8) étant mutuellement espacées et également espacées du bord du module solaire (4).

10. Procédé selon la revendication 9, comportant en outre les étapes suivantes :
- la mise à disposition d'au moins une boîte de pontage électrique (22), avec
• un élément d'agencement de boîte de pontage (24) et
• un dispositif de contact de boîte de pontage (54) pourvu de deux contacts conducteurs (56a, 56b) et d'au moins une diode (40) qui relie électriquement les deux contacts conducteurs (56a, 56b),
- l'agencement de la boîte de pontage (22) à l'aide de l'élément d'agencement de boîte de pontage (24) sur le module solaire (4), où deux des conducteurs électriques (10e, 10f) du module solaire (4) sont mis en contact respectivement avec un contact conducteur associé (56a, 56b) du dispositif de contact de boîte de pontage (54) et
où ladite au moins une boîte de pontage (22) est agencée, espacée de la boîte de jonction d'entrée (6) et de la boîte de jonction de sortie (8), sur le module solaire (4).

11. Procédé selon la revendication 10, où l'élément d'agencement de boîte de pontage (24) est un agent adhésif agencé sur le dispositif de contact de boîte de pontage (54) et où le dispositif de contact de boîte de pontage (54) est fixé, à l'aide de l'agent adhésif, sur le module solaire (4).

12. Procédé selon la revendication 9 à 11, comportant l'étape ultérieure :
- de séparation du dispositif de contact de boîte de jonction d'entrée (36) et/ou du dispositif de contact de boîte de jonction de sortie (46) et/ou dudit au moins un dispositif de contact de boîte de pontage (54) au niveau d'un point de rupture (42).

13. Procédé selon la revendication 9 à 12, comportant l'étape ultérieure :
- de remplissage de l'intérieur de la boîte de jonction d'entrée (6) et/ou de la boîte de jonction de sortie (8) et/ou de ladite au moins une boîte de pontage (22) avec de la résine synthétique ou un polymère ou un élastomère de sorte à fixer la boîte de jonction d'entrée (6) et/ou la boîte de jonction de sortie (8) et/ou ladite au moins une boîte de pontage (22) sur le module solaire (4).

14. Boîte de pontage (22), comportant :
- un élément d'agencement de boîte de pontage (24),
- un dispositif de contact de boîte de pontage (54) avec
• deux contacts conducteurs (56a, 56b),
• au moins une diode (40) qui relie électriquement les deux contacts conducteurs (56a, 56b) et
un agent adhésif directement agencé sur le dispositif de contact de boîte de pontage (54) avec lequel le dispositif de contact de boîte de pontage (54) peut être fixé sur le module solaire (4).

15. Boîte de pontage (22) selon la revendication 14, où l'agent adhésif comporte un adhésif sensible à la pression, un adhésif thermofusible et/ou une bande adhésive double face.
